# EUROPÄISCHE PATENTANMELDUNG

(11) **EP 4 624 858 A1**
(43) Veröffentlichungstag der Anmeldung: **01.10.2025**
(21) Anmeldenummer: 24217475.3
(22) Anmeldetag: 04.12.2024
(51) Int. Cl.: F28F 3/12

(54) **WÄRMEÜBERTRAGERPLATTE UND ZUGEHÖRIGE VERWENDUNG SOWIE ANORDNUNG EINER TRAKTIONSBATTERIE AN EINER WÄRMEÜBERTRAGERPLATTE**

(30) Priorität: 28.03.2024 DE 102024109025
(71) Anmelder: Mahle International GmbH, 70376 Stuttgart (DE)
(72) Erfinder: Maucher, Dr. Ulrich, 70825 Korntal-Münchingen (DE); Ferrand, Nicolas, 70191 Stuttgart (DE); Richter, Jens, 71723 Grossbottwar (DE)

(57) **Zusammenfassung**

Die vorliegende Erfindung betrifft eine Wärmeübertragerplatte (1) zum Temperieren von wenigstens einem elektrischen und/oder elektronischen Bauteil mittels eines flüssigen Temperiermittels, mit einem Plattenkörper (2), der einen Zulauf (IN), einen Ablauf (OUT) und ein Kanalsystem (7) aufweist, das den Zulauf (IN) mit dem Ablauf (OUT) verbindet.

Zur Homogenisierung einer Temperaturverteilung entlang des Plattenkörpers (2) wird vorgeschlagen, das Kanalsystem (7) einerseits so zu konfigurieren, dass ein durchströmbarer Querschnitt des Kanalsystems (7) in einem vom Zulauf (IN) wegführenden Eintrittsbereich (26) größer ist als in einem zum Ablauf (OUT) hinführenden Austrittsbereich (27), und andererseits so zu konfigurieren, dass ein mittlerer Strömungspfad im Kanalsystem (7) kleiner ist als ein Mindestpfad, den das Temperiermittel entlang eines Rands des Kanalsystems (7) vom Zulauf (IN) bis zum Ablauf (OUT) strömen muss.

## Beschreibung

Die vorliegende Erfindung betrifft eine Wärmeübertragerplatte zum Temperieren von wenigstens einem elektrischen und/oder elektronischen Bauteil mittels eines flüssigen Temperiermittels. Die Erfindung betrifft außerdem eine Verwendung einer derartigen Wärmeübertragerplatte. Des Weiteren betrifft die Erfindung eine Anordnung einer Traktionsbatterie an einer solchen Wärmeübertragerplatte.

Bei einer Vielzahl technischer Anwendungen muss Wärme von elektrischen Bauteilen abgeführt werden, um eine Überhitzung der Bauteile zu vermeiden bzw. um eine Alterung der Bauteile zu verlangsamen. Ebenso kann es bei bestimmten elektrischen Bauteilen und/oder bei bestimmten Betriebszuständen erforderlich sein, diese Bauteile zu erwärmen, um beispielsweise eine besonders hohe Effizienz zu erzielen. Beispielsweise für den Fall einer Traktionsbatterie eines batterieelektrischen Fahrzeugs kann es für einen optimierten Ladevorgang von Vorteil sein, die Batteriezellen der Traktionsbatterie auf eine Ladetemperatur zu erwärmen. Auch während der Leistungsabgabe der Traktionsbatterie kann es z.B. bei niedrigen Umgebungstemperaturen erforderlich sein, die Batteriezellen zu wärmen, um eine vorschnelle Entladung zu vermeiden. Im Unterschied dazu kann es bei einer starken Leistungsabgabe der Batterien erforderlich sein, diese zu kühlen, um eine Überhitzung der Batteriezellen zu vermeiden und auch um die energetische Effizienz zu verbessern.

Zum Temperieren, also zum Wärmen oder zum Kühlen, können Wärmeübertragerplatten zum Einsatz kommen, die von einem flüssigen Temperiermittel durchströmbar sind und die bei ihrer Verwendung mit dem jeweiligen zu temperierenden Bauteil, insbesondere mit einer Traktionsbatterie, wärmeübertragend in Kontakt stehen. Derartige Wärmeübertragerplatten zeichnen sich durch ihre flache und insbesondere ebene Bauform aus und benötigen wenig Einbauraum. Beispielsweise lassen sich derartige Wärmeübertragerplatten in einem Batteriegehäuse zur Aufnahme von Batteriezellen unterbringen.

Für den Fall, dass eine große Anzahl elektrischer oder elektronischer Bauteile oder ein entsprechend großes elektrisches Bauteil, wie z.B. eine Traktionsbatterie, möglichst gleichförmig temperiert werden soll, besteht bei einer Wärmeübertragerplatte, die einen Zulauf zum Zuführen des Temperiermittels und einen Ablauf zum Abführen des Temperiermittels aufweist, häufig das Problem, dass in einem das Temperiermittel führenden Kanalsystem, das im Inneren der Wärmeübertragerplatte ausgebildet ist und den Zulauf mit dem Ablauf fluidisch verbindet, die Wärme dem jeweiligen Bauteil nicht gleichförmig zugeführt bzw. von diesen nicht gleichförmig abgeführt wird, beispielsweise weil die Temperatur des Temperiermittels vom Zulauf bis zum Ablauf entlang des Kühlkanalsystems zwangsläufig abnimmt oder zunimmt, je nachdem, ob Wärme zugeführt oder abgeführt werden soll.

Die vorliegende Erfindung beschäftigt sich mit dem Problem, für eine Wärmeübertragerplatte der vorstehend beschriebenen Art bzw. für eine zugehörige Verwendung eine verbesserte Ausführungsform anzugeben, die sich insbesondere durch eine möglichst homogene Wärmeübertragungsleistung entlang der Wärmeübertragerplatte auszeichnet.

Dieses Problem wird erfindungsgemäß durch den Gegenstand des unabhängigen Anspruchs gelöst. Vorteilhafte Ausführungsformen sind Gegenstand der abhängigen Ansprüche.

Die Erfindung beruht auf dem allgemeinen Gedanken, das Kanalsystem, das im Inneren eines Plattenkörpers der Wärmeübertragerplatte ausgebildet ist, gemäß einem ersten Aspekt so zu konfigurieren, dass ein durchströmbarer Querschnitt des Kanalsystems in einem zulaufseitigen Eintrittsbereich größer ist als in einem ablaufseitigen Austrittsbereich, und gemäß einem zweiten Aspekt so zu konfigurieren, dass ein mittlerer Strömungspfad im Kanalsystem maximal 50%, vorzugsweise maximal 25%, größer ist als ein Mindestpfad oder Mindestweg, den das Temperiermittel entlang eines Rands des Kanalsystems vom Zulauf bis zum Ablauf strömen muss. Durch den ersten Aspekt strömt das Temperiermittel im Betrieb der Wärmeübertragerplatte im Austrittsbereich zwangsläufig schneller als im Eintrittsbereich. Die Strömungsgeschwindigkeit des Temperiermittels korreliert jedoch mit der Wärmeübertragungsleistung, so dass sich mit zunehmender Strömungsgeschwindigkeit die Wärmeübertragung verbessert. Während des Betriebs der Wärmeübertragerplatte hat im Eintrittsbereich bereits eine Wärmeübertragung stattgefunden, so dass die Temperaturdifferenz zwischen dem Temperiermittel und dem jeweiligen Bereich der Wärmeübertragerplatte im Austrittsbereich reduziert ist. Zur Homogenisierung der Wärmeübertragungsleistung entlang des Kanalsystems kann die reduzierte Temperaturdifferenz im Austrittsbereich durch die höhere Strömungsgeschwindigkeit im Austrittsbereich weitgehend kompensiert werden. Untersuchungen der Anmelderin haben gezeigt, dass der zweite Aspekt den Effekt des ersten Aspekts signifikant verbessert und damit entscheidend zur Homogenisierung der Wärmeübertragungsleistung entlang der Wärmeübertragerplatte beiträgt. Entlang des Strömungswegs entsteht ein Druckverlust im Temperiermittel. Bei einem engen Kanalquerschnitt führt die dann erhöhte Strömungsgeschwindigkeit zu einem sehr starken Druckverlustanstieg. Durch die Kombination eines möglichst großen Kanalquerschnitts mit möglichst kurzen Kanälen kann in Bereichen niedrigerer Kühlanforderung mit minimiertem Druckverlust und damit minimaler Pumpleistung zum Antreiben des Temperiermittels ein sehr großer Bereich der Wärmeübertragerplatte gekühlt werden. Der zweite Aspekt der maximalen Strömungsweglänge führt damit zu einer Druckverlustoptimierung bzw. Effizienzsteigerung der Wärmeübertragerplatte. Dabei wirkt diese Optimierung bzw. Effizienzsteigerung umso besser, je kleiner das Verhältnis von mittlerer Strömungspfadlänge zur Pfadlänge des größeren Mindestpfads ausfällt.

Im vorliegenden Zusammenhang ist eine "Konfiguration" gleichbedeutend mit einer "Ausgestaltung", sodass die Formulierung "so konfiguriert, dass" gleichbedeutend ist mit der Formulierung "so ausgestaltet, dass".

Konkret definiert das Kanalsystem für das im Kanalsystem vom Zulauf zum Ablauf strömende Temperiermittel eine Hauptströmungsrichtung, wobei das Kanalsystem bezüglich der Hauptströmungsrichtung eine linke Kanalbegrenzungskontur und eine rechte Kanalbegrenzungskontur aufweist, die einen dem Temperiermittel zur Durchströmung zur Verfügung stehenden Querschnitt des Kanalsystems quer zur Hauptströmungsrichtung begrenzen. Das Kanalsystem definiert ferner einen linken Mindestweg, der vom Zulauf entlang der linken Kanalbegrenzungskontur zum Ablauf führt, und einen rechten Mindestweg, der vom Zulauf entlang der rechten Kanalbegrenzungskontur zum Ablauf führt. Das Kanalsystem weist eine vom Zulauf zum Ablauf führende Kanalsystemgesamtlänge auf. Das Kanalsystem ist erfindungsgemäß so konfiguriert, dass die Kanalsystemgesamtlänge maximal 50%, insbesondere maximal 25%, größer ist als der größere Weg von linkem und rechtem Mindestweg oder maximal 50%, insbesondere maximal 25%, größer ist als der linke oder rechte Mindestweg, wenn der linke Mindestweg und der rechte Mindestweg gleich groß sind. Des Weiteren weist das Kanalsystem einen Eintrittsbereich auf, der eine Eintrittsbereichslänge aufweist, die sich über 20% bis 40% und vorzugsweise über 25% bis 35% der Kanalsystemgesamtlänge erstreckt. Außerdem weist das Kanalsystem einen Austrittsbereich auf, der eine Austrittsbereichslänge aufweist, die sich über 20% bis 40% und vorzugsweise über 25% bis 35% der Kanalsystemgesamtlänge erstreckt. Ein Verbindungsbereich des Kanalsystems verbindet den Eintrittsbereich mit dem Austrittsbereich. Erfindungsgemäß ist das Kanalsystem nun so konfiguriert, dass ein dem Temperiermittel im Eintrittsbereich zur Durchströmung zur Verfügung stehender mittlerer Eintrittsbereichsquerschnitt größer ist als ein im Austrittsbereich dem Temperiermittel zur Durchströmung zur Verfügung stehender mittlerer Austrittsbereichsquerschnitt.

Der Zulauf weist dabei zumindest einen Zulaufanschluss zum Anschließen einer Zulaufleitung zum Zuführen des Temperiermittels auf. Üblicherweise weist der Zulauf nur einen Zulaufanschluss auf. Es kann jedoch vorteilhaft sein, zwei oder mehr separate Zulaufanschlüsse vorzusehen, die dann gemeinsam den Zulauf bilden.

Der Ablauf weist dabei zumindest einen Ablaufanschluss zum Anschließen einer Ablaufleitung zum Abführen des Temperiermittels auf. Üblicherweise weist der Ablauf nur einen Ablaufanschluss auf. Es kann jedoch vorteilhaft sein, zwei oder mehr separate Ablaufanschlüsse vorzusehen, die dann gemeinsam den Ablauf bilden.

Untersuchungen der Anmelderin haben gezeigt, dass die Wärmeübertragungsleistung entlang der Wärmeübertragerplatte umso homogener über den gesamten temperierten Bereich der Wärmeübertragerplatte verteilt werden kann, je kleiner das Verhältnis ist von Kanalsystemgesamtlänge zu dem größeren Weg von linkem und rechtem Mindestweg, wenn diese unterschiedlich lang bzw. groß sind, oder von Kanalsystemgesamtlänge zu dem linken oder rechten Mindestweg, wenn diese gleich groß bzw. lang sind. Dementsprechend kann gemäß vorteilhaften Ausführungsformen vorgesehen sein, dass das Kanalsystem so konfiguriert ist, dass die Kanalsystemgesamtlänge maximal 40% oder maximal 30% oder maximal 25% oder maximal 20% oder maximal 15% oder maximal 10% oder maximal 5% größer ist als oder insbesondere maximal gleich groß ist wie der größere Weg von linkem und rechtem Mindestweg, wenn der linke Mindestweg und der rechte Mindestweg nicht gleich groß sind, oder maximal 40% oder maximal 30% oder maximal 25% oder maximal 20% oder maximal 15% oder maximal 10% oder maximal 5% größer ist als oder insbesondere maximal gleich groß ist wie der linke oder rechte Mindestweg, wenn der linke Mindestweg und der rechte Mindestweg gleich groß sind. In der Konsequenz kann sich eine besonders vorteilhafte Konfiguration ergeben, wenn die Kanalsystemgesamtlänge kleiner ist als der größere Weg von linkem und rechtem Mindestweg oder kleiner ist als der linke oder rechte Mindestweg, wenn der linke und rechte Mindestweg gleich groß sind.

Gemäß einer vorteilhaften Ausführungsform kann nun vorgesehen sein, dass das Kanalsystem einen den Zulauf aufweisenden Verteilerbereich aufweist, der eine Verteilerbereichslänge aufweist, dass das Kanalsystem einen den Ablauf aufweisenden Sammlerbereich aufweist, der eine Sammlerbereichslänge aufweist. Ferner kann das Kanalsystem innerhalb der Temperierzone einen Kontaktbereich bildet, der an der Plattenoberfläche zur wärmeübertragenden Kopplung mit dem jeweiligen zu temperierenden Bauteil konfiguriert ist und der eine Kontaktbereichslänge aufweist, die sich vom Verteilerbereich bis zum Sammlerbereich erstreckt, wobei sich der Eintrittsbereich innerhalb des Kontaktbereichs erstreckt und an den Verteilerbereich anschließt, wobei sich der Austrittsbereich innerhalb des Kontaktbereichs erstreckt und an den Sammlerbereich anschließt. Damit sind der Verteilerbereich mit dem Zulauf und der Sammlerbereich mit dem Ablauf von den vorstehend genannten Auslegungskriterien für die Aufteilung der Kanalsystemgesamtlänge auf die Bereichslängen ausgenommen, so dass sich die Auslegung genauer realisieren lässt. Insbesondere kann bei dieser Konfiguration der Kontaktbereich durch die vorgesehene Kontaktierung bzw. Belegung durch das jeweilige zu kühlende Bauteil herangezogen werden, so dass die Wärmeübertragerplatte hinsichtlich der tatsächlichen Temperierungsbedingungen konfektioniert werden kann.

Insbesondere kann dabei vorgesehen sein, dass die Eintrittsbereichslänge, die Austrittsbereichslänge und die Verbindungsbereichslänge jeweils 1/3 der Kontaktbereichslänge betragen. Hierdurch ergibt sich eine signifikante Vereinfachung der Auslegung.

Vorteilhaft ist eine Konfiguration, bei der die Verteilerbereichslänge und die Sammlerbereichslänge jeweils maximal 15% oder vorzugsweise maximal 10% der Kanalsystemgesamtlänge betragen. Durch dieses Auslegungskriterium ergibt sich eine indirekte Definition des Kontaktbereichs.

Bei einer anderen Ausführungsform kann vorgesehen sein, dass die Verteilerbereichslänge und die Sammlerbereichslänge jeweils 9,5% oder zusammen 19% der Kanalsystemgesamtlänge betragen, wobei außerdem vorgesehen ist, dass die Eintrittsbereichslänge, die Austrittsbereichslänge und die Verbindungsbereichslänge jeweils 27% oder zusammen 81% der Kanalsystemgesamtlänge betragen. Bei dieser Konfiguration kann der Kontaktbereich ebenfalls indirekt definiert werden.

Entsprechend einer vorteilhaften Ausführungsform kann vorgesehen sein, dass im Kanalsystem in der Hauptströmungsrichtung ein Abstand zwischen der linken und rechten Kanalbegrenzungskontur variiert. Das Kanalsystem kann zwischen dem Zulauf und dem Ablauf wenigstens einen Kanalabschnitt aufweisen, der sich in der Hauptströmungsrichtung von einem Extremum des Abstands bis zum nächstfolgenden Extremum des Abstands erstreckt. Das jeweilige Extremum kann ein Maximum oder ein Minimum sein. Die beiden Extrema sind ein Minimum und ein Maximum, so dass sich der jeweilige Kanalabschnitt von einem Minimum zu einem Maximum oder von einem Maximum zu einem Minimum erstreckt. Bei einem Kanalabschnitt, bei dem der Abstand zwischen der linken und rechten Kanalbegrenzungskontur konstant ist, erstreckt sich dieser Kanalabschnitt entlang des Extremums, das ein Minimum oder ein Maximum sein kann, so dass am Anfang und am Ende eines derartigen Kanalabschnitts jeweils ein Maximum oder ein Minimum vorliegen kann und den Übergang zum benachbarten Kanalabschnitt bildet. In einem solchen Kanalabschnitt bildet der Abstand ein Plateau. Das jeweilige Extremum ist dadurch definiert, dass im jeweiligen Extremum eine entlang des Abstands verlaufende Gerade senkrecht auf der linken Kanalbegrenzungskontur und senkrecht auf der rechten Kanalbegrenzungskontur steht. Der jeweilige Kanalabschnitt weist eine entlang einer Mittellinie des Kanalabschnitts gemessene Abschnittslänge auf. Die Mittellinie ist dabei durch die Mittelpunkte von Verbindungsgeraden gebildet, die jeweils einen Punkt der linken Kanalbegrenzungskontur, der an der linken Kanalbegrenzungskontur einen im Bereich von 0% bis 100% liegenden, prozentualen Längenanteil zwischen den beiden Extrema besitzt, mit einem Punkt der rechten Kanalbegrenzungskontur verbindet, der an der rechten Kanalbegrenzungskontur denselben prozentualen Längenanteil zwischen den Extrema besitzt. Beispielsweise verbinden eine solche Verbindungsgerade einen Punkt, der bei n%, z.B. bei 10%, der Länge der linken Kanalbegrenzungskontur liegt, mit einem Punkt der bei n%, z.B. bei 10%, der Länge der rechten Kanalbegrenzungskontur liegt. Der geometrische Mittelpunkt dieser Verbindungsgerade bildet dann einen Punkt entlang der Mittellinie. Bei 0% entspricht die Verbindungsgerade dem Extremum am Anfang des Kanalabschnitts und bei 100% entspricht die Verbindungsgerade dem Extremum am Ende des Kanalabschnitts. Damit ist die Abschnittslänge exakt definiert. Die Kanalsystemgesamtlänge ist nun durch die Summe der Abschnittslängen aller vom Zulauf bis zum Ablauf aufeinander folgender Kanalabschnitte gebildet. Damit ist die Kanalsystemgesamtlänge exakt definiert. Bei einem Zulauf mit nur einem Zulaufanschluss wird die geometrische Mitte des Zulaufanschlusses als Startpunkt der Mittellinie verwendet. Bei einem Zulauf mit mehreren Zulaufanschlüssen wird die geometrische Mitte einer die Zulaufanschlüsse umhüllenden Hüllkurve, die sogenannte "Umhüllende", als Startpunkt der Mittellinie verwendet. Bei einem Ablauf mit nur einem Ablaufanschluss wird die geometrische Mitte des Ablaufanschlusses als Endpunkt der Mittellinie verwendet. Bei einem Ablauf mit mehreren Ablaufanschlüssen wird die geometrische Mitte einer die Ablaufanschlüsse umhüllenden Hüllkurve, die sogenannte "Umhüllende", als Endpunkt der Mittellinie verwendet. Das Kanalsystem kann so konfiguriert sein, dass es nur einen einzigen Kanalabschnitt aufweist. Üblicherweise weist das Kanalsystem jedoch mehrere Kanalabschnitte auf, die in der Strömungsrichtung des Temperiermittels unmittelbar aufeinanderfolgen. Bei zwei aufeinanderfolgenden Kanalabschnitten, die einen im Betrieb der Wärmeübertragerplatte zuerst vom Temperiermittel durchströmten stromaufliegenden Kanalabschnitt und einen danach vom Temperiermittel durchströmten stromabliegenden Kanalabschnitt bilden, bildet das Extremum am Ende des stromaufliegenden Kanalabschnitts gleichzeitig das Extremum am Anfang des stromabliegenden Kanalabschnitts. Mit anderen Worten, das jeweilige Extremum bildet den Übergang von zwei benachbarten Kanalabschnitten. Bei eben konfigurierter Wärmeübertragerplatte definiert die Wärmeübertragerplatte eine Plattenebene und die genannten Abstände, Extrema, Geraden und Verbindungsgeraden erstrecken sich parallel zur Plattenebene. Insbesondere liegen die genannten Abstände, Extrema, Geraden und Verbindungsgeraden in einer Ebene, die parallel zur Plattenebene verläuft.

Der Abstand kann an der linken und rechten Kanalbegrenzungskontur bezüglich der Höhenrichtung jeweils vorzugsweise mittig in einem Bereich mit dem größten Neigungswinkel gegenüber der Plattenebene gemessen werden. Bei geraden Kanalbegrenzungskonturen ist die Neigung zur Plattenebene entlang der Kanalbegrenzungskontur konstant, sodass die Abstandsmessung bezüglich der Höhenrichtung in der Mitte der jeweiligen Kanalbegrenzungskontur erfolgt. Bei gekrümmten Kanalbegrenzungskonturen wird die steilste Stelle der Kanalbegrenzungskontur zur Abstandsmessung herangezogen. Ist diese steilste Stelle ein Punkt der jeweiligen Kanalbegrenzungskontur, erfolgt die Abstandsmessung bezüglich der Höhenrichtung in diesem Punkt. Ist diese steilste Stelle ein gerader Bereich der jeweiligen Kanalbegrenzungskontur mit konstanter Neigung, erfolgt die Abstandsmessung bezüglich der Höhenrichtung in der Mitte dieses geraden Bereichs.

Entsprechend einer vorteilhaften Ausführungsform kann vorgesehen sein, dass der mittlere Eintrittsbereichsquerschnitt durch ein dem Temperiermittel im Eintrittsbereich zur Durchströmung zur Verfügung stehendes Eintrittsbereichsvolumen bezogen auf die Eintrittsbereichslänge gebildet ist, und/oder dass der mittlere Austrittsbereichsquerschnitt durch ein dem Temperiermittel im Austrittsbereich zur Durchströmung zur Verfügung stehendes Austrittsbereichsvolumen bezogen auf die Austrittsbereichslänge gebildet ist. Durch die Relativierung des Volumens mittels der Länge wird ein gemittelter durchströmbarer Querschnitt bereitgestellt, der einen Vergleich der durchströmbaren Querschnitte im Eintrittsbereich und im Austrittsbereich vereinfacht.

Entsprechend einer vorteilhaften Ausführungsform kann vorgesehen sein, dass die Eintrittsbereichslänge durch die Summe der Abschnittslängen aller im Eintrittsbereich liegender Kanalabschnitte gebildet ist. Zusätzlich oder alternativ kann vorgesehen sein, dass die Austrittsbereichslänge durch die Summe der Abschnittslängen aller im Austrittsbereich liegender Kanalabschnitte gebildet ist. Damit lassen sich die Eintrittsbereichslänge bzw. die Austrittsbereichslänge einfach und genau bestimmen.

Entsprechend einer vorteilhaften Ausführungsform kann vorgesehen sein, dass der mittlere Eintrittsbereichsquerschnitt mindestens 50% größer ist als der mittlere Austrittsbereichsquerschnitt. Untersuchungen der Anmelderin haben gezeigt, dass sich dadurch die Homogenisierung der Wärmeübertragung verbessert.

Zweckmäßig kann der mittlere durchströmbare Querschnitt im Eintrittsbereich ausgehend vom Zulauf bis zum Verbindungsbereich zunehmen. Im Austrittsbereich kann der durchströmbare Querschnitt vom Verbindungsbereich bis zum Auslaufanschluss bevorzugt abnehmen. Auch innerhalb des Verbindungsbereichs kann der durchströmbare Querschnitt vom eintrittsseitigen Übergang bis zum austrittsseitigen Übergang bevorzugt abnehmen.

Innerhalb des Plattenkörpers erstreckt sich das Kanalsystem in einer Temperierzone. Die Erfindung geht dabei von einer Wärmeübertragerplatte zum Temperieren von wenigstens einem elektrischen und/oder elektronischen Bauteil mittels eines flüssigen Temperiermittels aus, die einen Plattenkörper aufweist, der eine Plattenoberfläche zur wärmeübertragenden Kopplung mit dem jeweiligen zu temperierenden Bauteil und einen umlaufenden Plattenrand aufweist. Der Plattenkörper weist innerhalb des Plattenrands zumindest eine Temperierzone auf, die einen am Plattenkörper ausgebildeten Zulauf mit mindestens einem Zulaufanschluss zum Zuführen des Temperiermittels, einen am Plattenkörper ausgebildeten Ablauf mit mindestens einem Ablaufanschluss zum Abführen des Temperiermittels und ein im Plattenkörper ausgebildetes Kanalsystem zum Führen des Temperiermittels aufweist, das den Zulauf mit dem Ablauf fluidisch verbindet.

Entsprechend einer vorteilhaften Ausführungsform kann vorgesehen sein, dass der mittlere Eintrittsbereichsquerschnitt in einem Bereich von 70% bis 600%, vorzugsweise in einem Bereich von 100% bis 400%, des mittleren Austrittsbereichsquerschnitts liegt, jeweils einschließlich der Bereichsgrenzen. Es hat sich gezeigt, dass sich bei diesen Bereichen über die Kanalsystemgesamtlänge eine besonders homogene Wärmeübertragung erzielen lässt.

Entsprechend einer vorteilhaften Ausführungsform kann vorgesehen sein, dass ein dem Temperiermittel im Verbindungbereich zur Durchströmung zur Verfügung stehender mittlerer Verbindungsbereichsquerschnitt kleiner ist als der mittlere Eintrittsbereichsquerschnitt und größer ist als der mittlere Austrittsbereichsquerschnitt. Hier wird der Gedanke des abnehmenden Querschnitts zur Erhöhung der Strömungsgeschwindigkeit und zur Verbesserung der Wärmeübertragung konsequent auch im Verbindungsbereich umgesetzt.

Entsprechend einer vorteilhaften Ausführungsform kann vorgesehen sein, dass der mittlere Verbindungsbereichsquerschnitt durch ein dem Temperiermittel im Verbindungsbereich zur Durchströmung zur Verfügung stehendes Verbindungsbereichsvolumen bezogen auf eine Verbindungsbereichslänge gebildet ist, die sich vom Eintrittsbereich bis zum Austrittsbereich erstreckt. Das auf die Länge bezogene Volumen stellt einen einfach vergleichbaren Querschnitt zur Verfügung.

Entsprechend einer vorteilhaften Ausführungsform kann vorgesehen sein, dass die Verbindungsbereichslänge durch die Summe der Abschnittslängen aller im Verbindungsbereich liegender Kanalabschnitte gebildet ist. Auch dies vereinfacht die genaue Bestimmung der Verbindungsbereichslänge.

Entsprechend einer vorteilhaften Ausführungsform kann vorgesehen sein, dass das Kanalsystem so konfiguriert ist, dass es im Eintrittsbereich einen kleineren Wärmeübergangskoeffizienten aufweist als im Austrittsbereich und/oder im Verbindungsbereich. Dadurch kann der im Eintrittsbereich größere Volumenstrom zur Homogenisierung der Wärmeübertragungsleistung kompensiert werden. Entsprechend einer vorteilhaften Ausführungsform kann vorgesehen sein, dass das Kanalsystem im Eintrittsbereich und/oder im Austrittsbereich mehrere parallel vom Temperiermittel durchströmbare Kanäle aufweist. Durch die Anzahl solcher Kanäle lässt sich der zur Durchströmung vorgesehene Querschnitt besonders einfach variieren. Vorteilhaft ist nun eine Konfiguration, bei der eine Anzahl an Kanälen im Austrittsbereich im Bereich von 20 % bis 70 % von einer Anzahl an Kanälen im Eintrittsbereich liegt. Mit anderen Worten, im Austrittsbereich sind weniger Kanäle angeordnet als im Eintrittsbereich. Insbesondere befinden sich im Austrittsbereich Sammelkanäle, während im Eintrittsbereich Verteilerkanäle und auch zumindest teilweise Verbindungskanäle zu finden sind. Diese Sammelkanäle, Verteilerkanäle und Verbindungskanäle werden nachfolgend noch näher erläutert.

Gemäß einer bevorzugten Ausführungsform kann das jeweilige Kanalsystem mit mehreren Verteilerkanälen, mehreren Verbindungskanälen und mehreren Sammelkanälen ausgestattet sein, wobei die Verteilerkanäle mit dem Zulauf fluidisch verbunden sind und in die Verbindungskanäle verzweigen oder aufzweigen, während die Verbindungskanäle in die Sammelkanäle einmünden und die Sammelkanäle mit dem Ablauf fluidisch verbunden sind. Ferner werden im Kanalsystem dadurch ein äußerer Verteilerkanal und ein äußerer Sammelkanal definiert, die durch mehrere Verbindungskanäle miteinander verbunden sind und vergleichsweise nahe an einem Zonenrand der jeweiligen Temperierzone bzw. an einem Plattenrand des Plattenkörpers angeordnet sind. Letzteres kann insbesondere dann der Fall sein, wenn der Zonenrand mit dem Plattenrand zusammenfällt, vorzugsweise dann, wenn der Plattenkörper nur eine einzige Temperierzone aufweist. Außerdem werden mithilfe des Kanalsystems zumindest ein innerer Verteilerkanal und zumindest ein innerer Sammelkanal ausgebildet, die über mehrere Verbindungskanäle miteinander verbunden sind und die vom Zonenrand bzw. vom Plattenrand weiter entfernt sind als der äußere Verteilerkanal und der innere Verteilerkanal. Durch diese Bauweise wird eine gleichförmige Durchströmung eines äußeren Zonenabschnitts bzw. Plattenabschnitts, der zum Zonenrand bzw. Plattenrand benachbart ist und in dem der äußere Verteilerkanal und der äußere Sammelkanal sowie die zugehörigen Verbindungskanäle verlaufen, und eines inneren Plattenabschnitts erreicht, der vom Zonenrand bzw. Plattenrand weiter entfernt angeordnet ist und in dem der innere Verteilerkanal, der innere Sammelkanal und die zugehörigen Verbindungskanäle verlaufen. Zweckmäßig kann außerdem vorgesehen sein, dass der innere Sammelkanal und der äußere Sammelkanal etwa die gleiche Kanallänge bezüglich der Strömungsrichtung des Temperiermittels aufweisen. Dadurch kann ein mit der Kanallänge korrelierender Druckabfall im inneren Sammelkanal weitgehend gleich groß dimensioniert werden wie im äußeren Sammelkanal. Auch lässt sich dadurch eine annähernd gleiche Temperaturänderung im inneren Sammelkanal und im äußeren Sammelkanal realisieren. Diese Maßnahme unterstützt signifikant eine gleichförmige Durchströmung der Kanäle im inneren Plattenabschnitt und im äußeren Plattenabschnitt, wodurch eine homogene Temperierung unterstützt wird.

Im Einzelnen kann das Kanalsystem hierfür wenigstens zwei Verteilerkanäle aufweisen, die mit dem Zulauf fluidisch verbunden sind und die sich jeweils in mehrere gerade Verbindungskanäle aufzweigen, die vom Temperiermittel parallel durchströmt werden und insbesondere parallel zueinander verlaufen können. Ferner weist das Kanalsystem wenigstens zwei Sammelkanäle auf, die mit dem Ablauf fluidisch verbunden sind und in die jeweils mehrere der Verbindungskanäle einmünden.

Die effektive Länge kann bei einem geraden Kanalabschnitt durch den Abstand vom Einlass bis zum Auslass des geraden Kanalabschnitts gebildet sein. Die effektive Länge kann bei einem quer zur einer Hauptströmungsrichtung gewellten Kanalabschnitt durch den in der Hauptströmungsrichtung gemessenen Abstand vom Einlass bis zum Auslass des quer zur Hauptströmungsrichtung gewellten Kanalabschnitts gebildet sein. Die effektive Länge kann bei einem schlaufenförmigen oder schleifenförmigen Kanalabschnitt, der drei gerade Kanalabschnitte und zwei um 180° gebogene Kanalabschnitte aufweist, welche je zwei der geraden Kanalabschnitte miteinander verbinden, durch den Abstand vom Einlass des ersten geraden Kanalabschnitts, der über den ersten gebogenen Kanalabschnitt mit dem zweiten geraden Kanalabschnitt verbunden ist, bis zum Auslass des dritten geraden Kanalabschnitts gebildet sein, der über den zweiten gebogenen Kanalabschnitt mit dem zweiten geraden Kanalabschnitt verbunden ist.

Bei einem schlaufenförmigen oder schleifenförmigen Kanalabschnitt, der zwei gerade Kanalabschnitte und einen um 180° gebogenen Kanalabschnitt aufweist, der die beiden geraden Kanalabschnitte miteinander verbindet, kann sich eine relativ große Kanallänge vom Eingang des einen geraden Kanalabschnitts zum Ausgang des anderen geraden Kanalabschnitts ergeben. Derartige Längsschlaufen oder Längsschleifen können bei herkömmlichen Kanalsystemen zum Längenausgleich zwischen innenliegenden Pfaden und außenliegenden Pfaden zum Einsatz kommen. Insbesondere lassen sich damit sehr lange Pfade realisieren. Diese großen Pfadlängen vergrößern auch den mittleren Strömungspfad des Kanalsystems bzw. die Kanalsystemgesamtlänge, so dass der mittlere Strömungspfad bzw. die Kanalsystemgesamtlänge leicht mehr als 50% größer sein kann als der größere der beiden Mindestpfade bzw. Mindestwege, insbesondere dann, wenn eine solche Längsschleife zwischen den beiden Kanalbegrenzungskonturen angeordnet ist, so dass sie an der jeweiligen Kanalbegrenzungskontur den zugehörigen Mindestpfad bzw. Mindestweg nicht vergrößert. Auf derartige lange schlaufenförmige oder schleifenförmige Pfade wird durch die Vorgabe, dass der mittlere Strömungspfad bzw. die Kanalsystemgesamtlänge maximal 50% größer sein muss als der größere Mindestpfad bzw. Mindestweg, bei der erfindungsgemäßen Wärmeübertragerplatte verzichtet.

Da sich mit tiefen konturierten Kanälen mit niedrigerem Druckverlust die gleiche Leistung wie in flacheren nicht konturierten Kanälen erzielen lässt, erfolgt die Querschnittsreduzierung zum Austritt hin bevorzugt durch die Reduzierung der Anzahl paralleler Kanäle bzw. durch die Reduzierung der Breite der Kanäle. Beides führt zu einer Reduzierung der Gesamtbreite des von parallel verlaufenden Kanälen unterspülten Bereichs der Plattenoberfläche. Zur Erzielung besonders leistungsstarker Kanäle können aber auch reduzierte Kanalhöhen in Bereichen erhöhter Wärmeübertragungsanforderungen sinnvoll sein, um so eine zusätzliche Reduzierung des durchströmbaren Gesamtquerschnitts zu erreichen.

Der durchströmbare Querschnitt des jeweiligen Kanals ergibt sich im Wesentlichen aus der senkrecht zur Plattenebene gemessenen Kanalhöhe und der quer zur Kanalhöhe gemessenen Kanalbreite. Der dabei zu berücksichtigende Querschnitt erstreckt sich senkrecht zu einer neutralen Faser oder Mittellinie des jeweiligen Kanals. Bei einem Kanal mit im Wesentlichen gerade verlaufenden seitlichen Kanalbegrenzungen entspricht die Mittellinie der Mitte zwischen den seitlichen Kanalbegrenzungen. Sofern jedoch keine geraden seitlichen Kanalbegrenzungen vorliegen, ist die Ermittlung der Mittellinie und damit die Ermittlung des zu berücksichtigenden Querschnitts vergleichsweise komplex. Grundsätzlich können Strömungssimulationen herangezogen werden, um die Mittellinie und damit den zu berücksichtigenden durchströmbaren Querschnitt zu bestimmen.

Gemäß einer vorteilhaften Ausführungsform kann das Kanalsystem einen Außenpfad aufweisen, der durch einen der Verteilerkanäle, einen der Verbindungskanäle und einen der Sammelkanäle gebildet ist und sich entlang eines Zonenrands der Temperierzone erstreckt, wobei der Außenpfad maximal 30% länger ist als ein kürzester Verbindungsweg, der vom Zulauf zum Zonenrand, entlang des Zonenrands und entlang des Außenpfads und vom Zonenrand zum Ablauf führt. Typischerweise kann ein solcher Außenpfad den längsten Pfad innerhalb des jeweiligen Temperierzone bilden. Durch die hier vorgestellte Maßnahme wird erreicht, dass dieser längste Pfad möglichst kurz ausgestaltet wird, nämlich maximal 30% länger als der entlang des Zonenrands zum Verbinden des Zulaufs mit dem Ablauf mögliche kürzeste Pfad. Dies vereinfacht die Angleichung aller anderen Pfade an den Außenpfad hinsichtlich der Wärmeübertragungsleistung, was die angestrebte Homogenisierung begünstigt.

Das Kanalsystem kann mehrere Pfade aufweisen, die jeweils das Temperiermittel vom Zulauf durch einen der Verteilerkanäle, einen der Verbindungskanäle und einen der Sammelkanäle zum Ablauf führen und jeweils eine Pfadlänge aufweisen. Diese Pfade können unterschiedliche Pfadlängen aufweisen. Der Pfad, der die größte Pfadlänge besitzt, definiert den längsten Pfad. Bei einer andere vorteilhaften Ausführungsform kann vorgesehen sein, dass jeder Pfad, dessen Pfadlänge kleiner ist als 50%, insbesondere kleiner ist als 60%, vorzugsweise kleiner ist als 75%, der Pfadlänge des längsten Pfads, einen kurzen Pfad bildet. Bevorzugt ist eine Konfiguration, bei der die Summe der kleinsten durchströmbaren Querschnitte aller kurzen Pfade kleiner ist als 40%, insbesondere kleiner ist als 20%, vorzugsweise kleiner ist als 10%, der Summe der durchströmbaren Querschnitte aller anderen Pfade. Denknotwendig beinhalten dabei "alle anderen Pfade" zumindest den längsten Pfad und - falls vorhanden - jeden weiteren Pfad, dessen Pfadlänge größer ist als 50%, insbesondere größer ist als 60%, vorzugsweise größer ist als 75%, der Pfadlänge des längsten Pfads. Diese weiteren Pfade können auch als lange Pfade aufgefasst werden. Sofern zwei oder mehr Pfade mit gleicher Pfadlänge existieren, die länger bzw. größer ist als die Pfadlänge aller anderen Pfade, kann einer dieser Pfade den längsten Pfad bilden, während der oder die anderen dieser Pfade dann jeweils einen langen Pfad bzw. einen der weiteren Pfade bilden.

Zweckmäßig können die Verteilerkanäle zumindest einen inneren Verteilerkanal und einen äußeren Verteilerkanal bilden, wobei der äußere Verteilerkanal direkt benachbart zum Zonenrand bzw. zum Plattenrand verläuft und damit näher am Zonenrand bzw. Plattenrand verläuft als der jeweilige innere Verteilerkanal, insbesondere als der zum äußeren Verteilerkanal direkt benachbarte innere Verteilerkanal. Analog dazu bilden die Sammelkanäle zumindest einen inneren Sammelkanal und einen äußeren Sammelkanal, wobei der äußere Sammelkanal direkt benachbart zum Zonenrand bzw. Plattenrand verlauft und damit näher am Zonenrand bzw. Plattenrand verläuft als der jeweilige innere Sammelkanal, insbesondere als der zum äußeren Sammelkanal direkt benachbarte innere Sammelkanal. In den äußeren Sammelkanal münden wenigstens zwei Verbindungskanäle ein, die vom äußeren Verteilerkanal abzweigen. In den inneren Sammelkanal münden wenigstens zwei Verbindungskanäle ein, die vom inneren Verteilerkanal abzweigen. Diese Maßnahme vereinfacht die Homogenisierung des Kanalsystems über die Fläche der jeweiligen Temperierzone.

Der innere Sammelkanal weist in einer Strömungsrichtung des Temperiermittels eine Kanallänge auf. Der äußere Sammelkanal weist in der Strömungsrichtung des Temperiermittels eine Kanallänge auf. Zweckmäßig kann nun vorgesehen sein, dass der innere Sammelkanal und der äußere Sammelkanal im Plattenkörper so verlaufen, dass die Kanallänge des inneren Sammelkanals mindestens 75 % der Kanallänge des äußeren Sammelkanals beträgt. Damit ist der innere Sammelkanal nicht oder nicht viel kürzer als der äußere Sammelkanal, was die angestrebte Homogenisierung der Wärmeübertragungsleistung begünstigt.

Vorteilhaft ist eine Ausführungsform, bei welcher die Kanallänge des inneren Sammelkanals mindestens 80 %, vorzugsweise mindestens 85 %, insbesondere mindestens 90 %, der Kanallänge des äußeren Sammelkanals beträgt. Da damit besitzen der innere Sammelkanal und der äußere Sammelkanal im Wesentlichen die gleiche Kanallänge.

Die optionale parallele Ausrichtung der Verbindungskanäle ermöglicht eine weitgehend homogene Temperierung des betroffenen Bereichs des Plattenkörpers.

Bevorzugt ist eine Ausführungsform, bei welcher der innere Sammelkanal, insbesondere im Unterschied zum äußeren Sammelkanal, einen Schlaufenabschnitt und/oder einen Mäanderabschnitt zum Vergrößern der Kanallänge des inneren Sammelkanals aufweist. Da der innere Sammelkanal innerhalb des Plattenkörpers weiter vom Plattenrand entfernt ist, kann er durch geradlinige Kanalabschnitte nicht die gleiche Länge erzielen wie der äußere Sammelkanal. Durch die Integration eines Mäanderabschnitts oder eines Schlaufenabschnitts kann dies kompensiert werden. Ein Schlaufenabschnitt repräsentiert dabei einen Umweg im Vergleich zu einer direkten oder geraden Verbindung. Ein Schlaufenabschnitt kann dabei drei gerade Längsabschnitte und zwei Bogenabschnitte aufweisen. Die drei Längsabschnitte bilden einen ersten, einen zweiten und einen dritten längsabschnitt, verlaufen parallel zueinander und sind quer zu ihrer Längsrichtung nebeneinander angeordnet. Die beiden Bogenabschnitte bilden einen ersten und zweiten Bogenabschnitt und erzeugen jeweils eine Strömungsumlenkung um 180°. Der erste Längsabschnitt weist einen Einlass des Schlaufenabschnitts auf und ist über den ersten Bogenabschnitt mit dem zweiten Längsabschnitt verbunden. Der zweite Längsabschnitt ist über den zweiten Bogenabschnitt mit dem dritten Längsabschnitt verbunden. Der dritte Längsabschnitt weist einen Auslass des Schlaufenabschnitts auf. Alternativ dazu kann ein Schlaufenabschnitt auch so konfiguriert sein, dass er zwei gerade Kanalabschnitte, einen um 180° gebogenen Kanalabschnitt und zwei um 90° gebogene Kanalabschnitte aufweist. Der 180° Bogenabschnitt verbindet die beiden geraden Kanalabschnitte. Der eine 90° Bogenabschnitt verbindet einen Einlass des Schlaufenabschnitts mit dem ersten geraden Kanalabschnitt. Der andere 90° Bogenabschnitt verbinden den zweiten geraden Kanalabschnitt mit einem Auslass des Schlaufenabschnitts.

Ein Mäanderabschnitt repräsentiert mindestens vier unmittelbar aufeinanderfolgende Bogenabschnitte, die einen 90°-Bogen mit einem Einlass des Mäanderabschnitts, einen 90°-Bogen mit einem Auslass des Mäanderabschnitts und zwei oder mehr 180°-Bogen bilden, die den einlassseitigen 90°-Bogen mit dem auslassseitigen 90°-Bogen verbinden.

Gemäß einer anderen Ausführungsform können der innere Sammelkanal und der äußere Sammelkanal jeweils wenigstens zwei Längsabschnitte aufweisen, in denen der innere Sammelkanal und der äußere Sammelkanal parallel zu benachbarten Längsabschnitten des Zonenrands bzw. des Plattenrands verlaufen. Hierdurch ergibt sich eine möglichst gleichförmige und homogene Temperierung des Plattenkörpers entlang des Plattenrands.

Bei einer anderen Ausführungsform kann vorgesehen sein, dass wenigstens ein vom inneren Verteilerkanal abzweigender Verbindungskanal in den äußeren Sammelkanal einmündet. Alternativ dazu kann ebenfalls vorgesehen sein, dass wenigstens ein vom äußeren Verteilerkanal abzweigender Verbindungskanal in den inneren Sammelkanal einmündet. Hierdurch wird die Homogenisierung der Temperierung zusätzlich verbessert. Es ist klar, dass bei einer derartigen Ausführungsform wenigstens einer der beiden Verteilerkanäle in wenigstens drei Verbindungskanäle aufzweigt.

Zweckmäßig können die Verbindungskanäle weitgehend parallel zu einem Längsabschnitt des Zonenrands bzw. des Plattenrands verlaufen. Durch die parallele Ausrichtung der Verbindungskanäle zu einem Längsabschnitt des Zonenrands bzw. Plattenrands ergeben sich eine besonders kompakte Bauform für die Wärmeübertragerplatte und eine homogene Temperaturverteilung bis zum Zonenrand bzw. Plattenrand.

Zweckmäßig erstreckt sich die Wärmeübertragerplatte bzw. ihr Plattenkörper in einer Plattenebene. Vorzugsweise besitzt die Wärmeübertragerplatte bzw. ihr Plattenkörper in der Plattenebene einen rechteckigen Querschnitt. Dementsprechend besitzt der Plattenrand zwei längere geradlinige Längsabschnitte und zwei kürzere geradlinige Längsabschnitte.

Bei einer anderen vorteilhaften Ausführungsform können der innere Sammelkanal und der äußere Sammelkanal jeweils einen Längsabschnitt aufweisen, der parallel zu den Verbindungskanälen verläuft. Auch dies unterstützt eine kompakte Bauform der Wärmeübertragerplatte, wobei vergleichsweise viel Volumen innerhalb des Plattenkörpers für die Kanäle des Kanalsystems bereitgestellt wird.

Gemäß einer besonders vorteilhaften Ausführungsform kann vorgesehen sein, dass die Kanäle im Austrittsbereich und/oder die Sammelkanäle einen größeren Wärmeübergangskoeffizienten aufweisen als die Kanäle im Eintrittsbereich und/oder die Verteilerkanäle und/oder die Verbindungskanäle. Diese Ausführungsformen beruhen auf der Überlegung, dass die Wärmeübertragungsleistung einerseits von der Temperaturdifferenz zwischen dem Temperiermittel und dem Plattenkörper und andererseits vom Wärmeübergangskoeffizienten zwischen dem Temperiermittel und dem Plattenkörper abhängt. Die Temperaturdifferenz zwischen dem Temperiermittel und dem Plattenkörper nimmt im Kanalsystem auf dem Weg vom Zulauf zum Ablauf zwangsläufig ab. Die Erhöhung des Wärmeübergangskoeffizienten im Bereich der Sammelkanäle kann dies kompensieren, um die Wärmeübertragung über die gesamte Wärmeübertragerplatte zu homogenisieren. Der Wärmeübergangskoeffizienten berücksichtigt dabei Parameter, die für den Wärmeübergang zwischen dem Temperiermittel und dem Plattenkörper verantwortlich sind, ausgenommen die Zusammensetzung des Temperiermittels und die Temperaturdifferenz zwischen Temperiermittel und Plattenkörper. Parameter, die vom Wärmeübergangskoeffizienten berücksichtigt werden können, sind beispielsweise die aktuelle Strömungsgeschwindigkeit des Temperiermittels im jeweiligen Kanal und/oder die Beschaffenheit der Strömung des Temperiermittels im jeweiligen Kanal, beispielsweise kann die Strömung laminar oder mehr oder weniger turbulent sein, und/oder die für die Wärmeübertragung jeweils zur Verfügung stehende Oberfläche, die mit dem Temperiermittel in Kontakt kommt, und/oder der im Temperiermittel herrschende Druck. Ein weiterer Parameter, der vom Wärmeübergangskoeffizienten berücksichtigt werden kann, ist die Wärmeleitfähigkeit der beteiligten Materialien. Da das Material des Plattenkörpers zweckmäßig bei allen Kanälen gleich ist, können derartige Materialunterschiede beispielsweise bei Wärmeleitelementen eine Rolle spielen, die in die Kanäle eingesetzt oder darin ausgebildet sein können.

Durch die Erhöhung des Wärmeübergangskoeffizienten im Bereich der Sammelkanäle gegenüber den Verbindungskanälen kann eine reduzierte Temperatur des Temperiermittels in den Sammelkanälen gegenüber den Verbindungskanälen kompensiert werden, sodass letztlich im Bereich der Verbindungskanäle einerseits und im Bereich der Sammelkanäle andererseits weitgehend die gleiche Wärmeübertragungsleistung realisierbar ist. Bei dieser Ausführungsform erfolgt die Wärmeübertragung im Bereich der Verbindungskanäle hauptsächlich auf Basis der höheren Temperaturdifferenz zwischen Temperiermittel und Plattenkörper. Im Unterschied dazu erfolgt die Wärmeübertragung im Bereich der Sammelkanäle hauptsächlich auf Basis des erhöhten Wärmeübergangskoeffizienten.

Zweckmäßig kann der durchströmbare Querschnitt des jeweiligen Sammelkanals kleiner sein als die Summe der durchströmbaren Querschnitte der darin einmündenden Verbindungskanäle. Hierdurch wird erreicht, dass in den Sammelkanälen eine höhere Strömungsgeschwindigkeit herrscht als in den Verbindungskanälen. Außerdem erhöht sich dadurch im Temperiermittel innerhalb der Sammelkanäle der Druck. Diese Maßnahmen verbessern die Wärmeübertragung im Bereich der Sammelkanäle.

Eine andere Ausführungsform schlägt vor, dass ein Durchströmungswiderstand im jeweiligen Sammelkanal größer ist als in den darin einmündenden Verbindungskanälen. Durch den höheren Durchströmungswiderstand verändert sich die Strömung des Temperiermittels. Einerseits nimmt dadurch der Druck im Temperiermittel zu. Andererseits kann auch die Turbulenz in der Strömung zunehmen. Diese Maßnahmen verbessern die Wärmeübertragung im Bereich der Sammelkanäle.

Gemäß einer anderen Ausführungsform kann vorgesehen sein, dass in den Sammelkanälen, insbesondere im Unterschied zu den darin einmündenden Verbindungskanälen, Wärmeleitelemente angeordnet sind, welche die Wärmeübertragung zwischen dem Temperiermittel und dem Plattenkörper verbessern. Diese Maßnahmen verbessern die Wärmeübertragung im Bereich der Sammelkanäle.

Sofern sowohl in den Sammelkanälen als auch in den Verbindungskanälen Wärmeleitelemente angeordnet sind, kann gemäß einer vorteilhaften Ausführungsform vorgesehen sein, dass die Wärmeleitelemente, die in den Sammelkanälen angeordnet sind, eine größere Anzahl und/oder eine größere Anordnungsdichte und/oder eine größere dem Temperiermittel ausgesetzte Oberfläche und/oder eine größere Wärmeleitfähigkeit aufweisen als die Wärmeleitelemente, die in den Verbindungskanälen angeordnet sind. Auch diese Maßnahmen unterstützen jeweils für sich und kumuliert sowie in beliebiger Kombination, die Wärmeübertragung in den Sammelkanälen.

Insbesondere kann daher vorgesehen sein, dass eine Anzahl an Verbindungskanälen mindestens doppelt so groß ist wie oder mehr als doppelt so groß ist wie eine Anzahl an Sammelkanälen. Beispielsweise ist eine Konfiguration denkbar, bei der sechs Verbindungskanäle und nur zwei Sammelkanäle vorgesehen sind. Auch ist eine Konfiguration denkbar, bei der acht Verbindungskanäle und drei Sammelkanäle vorgesehen sind.

Bei einer anderen Ausführungsform kann vorgesehen sein, dass der Zulauf und der Ablauf am Plattenkörper an demselben Endabschnitt des Plattenkörpers nebeneinander angeordnet sind, vorzugsweise an einem Längsende des Plattenkörpers. Hierdurch wird eine U-Konfiguration für das Kanalsystem innerhalb der zugehörigen Temperierzone erzielt. Vorteilhaft können nun der äußere Verteilerkanal, der zum Plattenrand direkt benachbarte Verbindungskanal und der äußere Sammelkanal im Kanalsystem einen entlang des Plattenrands umlaufenden Randkanal bilden, der den Zulauf mit dem Ablauf fluidisch verbindet und sich dabei entlang des Plattenrands erstreckt. Hierdurch wird eine homogene Verteilung der Wärmeübertragungsleistung entlang des Plattenkörpers unterstützt. Alternativ dazu ist auch eine Ausführungsform denkbar, bei der sich der Zulauf und der Ablauf an voneinander abgewandten Längsenden des Plattenkörpers befinden.

Bei einer alternativen Ausführungsform kann vorgesehen sein, dass der Zulauf und der Ablauf an voneinander abgewandten Endabschnitten des Plattenkörpers am Plattenkörper angeordnet sind. Hierdurch wird eine I-Konfiguration für das Kanalsystem innerhalb der zugehörigen Temperierzone erzielt. Hierdurch wird ein symmetrischer Aufbau des Kanalsystems begünstigt.

Bei einer anderen Ausführungsform kann vorgesehen sein, dass das Kanalsystem durch einen einzigen mäandrierenden Kanal gebildet ist, der den Zulauf mit dem Ablauf verbindet. Auch dies begünstigt einen einfachen Aufbau.

Besonders vorteilhaft ist eine Ausführungsform, bei welcher der Kanal eine Vielzahl separater, ungleicher und asymmetrisch verteilter und vom Temperiermittel umströmbarer Konturen zur Strömungsführung und Wärmeübertragung aufweist. Insbesondere kann dadurch eine Konfiguration erzielt werden, die auch in der DE 10 2023 118 768 offenbart ist, deren Offenbarungsgehalt hiermit durch ausdrückliche Bezugnahme zum Inhalt der vorliegenden Offenbarung hinzugefügt wird.

Bei einer anderen Ausführungsform kann vorgesehen sein, dass sich die im Austrittsbereich ausgebildeten Konturen durch eine größere Anordnungsdichte und/oder durch kleinere Abstände voneinander und/oder durch kleinere Abmessungen von den im Eintrittsbereich angeordneten Konturen unterscheiden. Damit kann die angestrebte Homogenisierung unterstützt werden.

Gemäß einer besonders vorteilhaften Ausführungsform kann vorgesehen sein, dass der Plattenkörper innerhalb des Plattenrands wenigstens zwei derartige Temperierzonen aufweist, die jeweils einen am Plattenkörper ausgebildeten Zulauf zum Zuführen des Temperiermittels, einen am Plattenkörper ausgebildeten Ablauf zum Abführen des Temperiermittels und ein im Plattenkörper ausgebildetes Kanalsystem zum Führen des Temperiermittels aufweist, das den Zulauf mit dem Ablauf fluidisch verbindet. Damit weist der Plattenkörper wenigstens zwei separate Zulauf, wenigstens zwei separate Ablauf und wenigstens zwei separate Kanalsysteme auf. Zweckmäßig kann nun vorgesehen sein, dass mindestens zwei der Temperierzonen hinsichtlich des jeweiligen Zulaufs, des jeweiligen Ablauf und des jeweiligen Kanalsystems identisch oder spiegelsymmetrisch oder unterschiedlich ausgestaltet sind.

Ebenso ist eine Konfiguration vorteilhaft, bei welcher der Plattenkörper nur eine einzige Temperierzone aufweist. Insbesondere kann dann der Zonenrand mit dem Plattenrand zusammenfallen.

Eine erfindungsgemäße Verwendung einer Wärmeübertragerplatte der vorstehend beschriebenen Art zeichnet sich dadurch aus, dass die Wärmeübertragerplatte zum Temperieren von Batteriezellen einer Traktionsbatterie eines batterieelektrischen Fahrzeugs verwendet wird. Mithilfe der hier vorgestellten Wärmeübertragerplatte lassen sich eine vergleichsweise große Anzahl einzelner Batteriezellen weitgehend gleichförmig Temperieren, sodass eine Überhitzung oder Unterkühlung einzelner Batteriezellen innerhalb der Traktionsbatterie vermieden werden kann.

Eine erfindungsgemäße Anordnung einer Traktionsbatterie an einer Wärmeübertragerplatte der vorstehend beschriebenen Art charakterisiert sich dadurch, dass die Traktionsbatterie innerhalb des Kontaktbereichs an der Plattenoberfläche angeordnet und mit der Wärmeübertragerplatte wärmeübertragend gekoppelt ist. Insbesondere definieren damit die Dimensionen der Traktionsbatterie die Ausdehnung des Kontaktbereichs innerhalb des Kanalsystems. Mit anderen Worten, der Verteilerbereich und der Sammlerbereich liegen jeweils außerhalb der Traktionsbatterie, während der Kontaktbereich von der Traktionsbatterie abgedeckt ist.

Die Anordnung der Traktionsbatterie an der Wärmeübertragerplatte entspricht dabei einer Einheit aus der Traktionsbatterie und der Wärmeübertragerplatte, bei der die Traktionsbatterie innerhalb des Kontaktbereichs an der Plattenoberfläche angeordnet und mit der Wärmeübertragerplatte wärmeübertragend gekoppelt ist.

Die Traktionsbatterie kann dabei als einheitliche Baugruppe direkt an der Wärmeübertragerplatte angeordnet sein. Die Traktionsbatterie weist üblicherweise eine Vielzahl von Batteriezellen auf. Grundsätzlich können die Batteriezellen direkt an der Wärmeübertragerplatte angeordnet sein. Ebenso ist denkbar, dass die Traktionsbatterie mehrere Batteriemodule aufweist, die jeweils mehrere Batteriezellen aufweisen. In diesem Fall können die Batteriemodule direkt an der Wärmeübertragerplatte angeordnet sein.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den durch die Ansprüche definierten Rahmen der Erfindung zu verlassen. Vorstehend genannte und nachfolgend noch zu nennende Bestandteile einer übergeordneten Einheit, wie z.B. einer Einrichtung, einer Vorrichtung oder einer Anordnung, die separat bezeichnet sind, können separate Bauteile bzw. Komponenten dieser Einheit bilden oder integrale Bereiche bzw. Abschnitte dieser Einheit sein, auch wenn dies in den Zeichnungen anders dargestellt ist.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch,
- Figuren 1 bis 14: jeweils eine Draufsicht auf eine Wärmeübertragerplatte mit einem Transparent dargestellten Plattenkörper bei verschiedenen Ausführungsformen,
- Figuren 15 bis 17: jeweils eine Schnittansicht im Bereich eines Kanals bei unterschiedlichen Kanalbegrenzungskonturen.

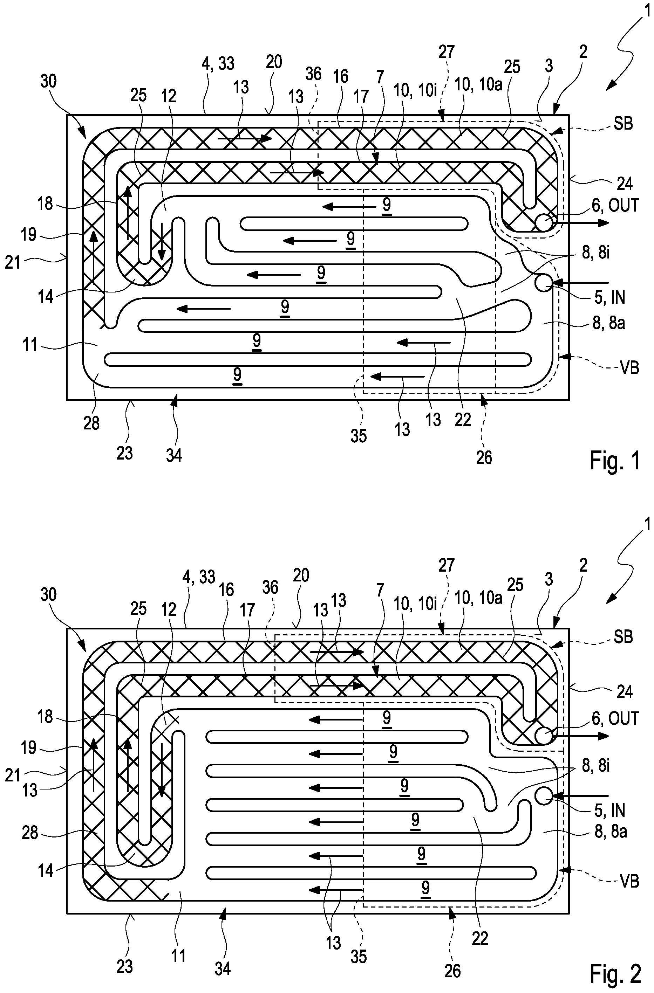

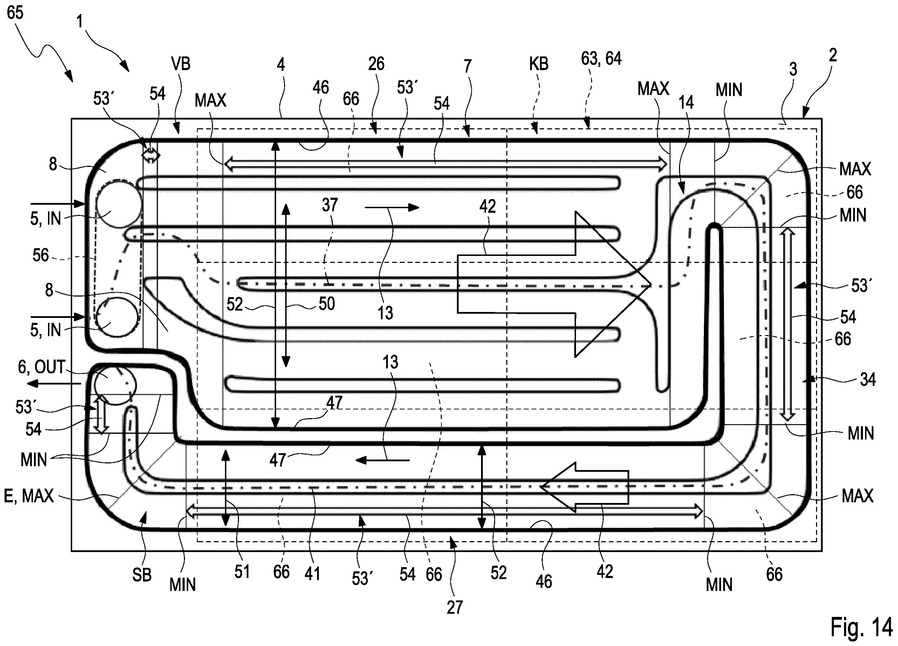

Entsprechend den Figuren 1 bis 14 umfasst eine Wärmeübertragerplatte 1, die zum Temperieren von mindestens einem elektrischen und/oder elektronischen Bauteil mittels eines flüssigen Temperiermittels dient, einen Plattenkörper 2, der eine Plattenoberfläche 3 zur wärmeübertragenden Kopplung mit dem jeweiligen zu temperierenden Bauteil aufweist. Diese Plattenoberfläche 3 kann sich dabei an einer in den Figuren dem Betrachter zugewandten Plattenoberseite befinden. Zusätzlich oder alternativ kann sich diese Plattenoberfläche 3 an einer in den Figuren vom Betrachter abgewandten Plattenunterseite befinden. Das zu temperierende Bauteil ist stellvertretend nur in Figur 14 mit unterbrochener Linie dargestellt und mit 63 bezeichnet. Bei einer bevorzugten Anwendung der hier vorgestellten Wärmeübertragerplatte 1 kann es sich bei dem zu temperierenden Bauteil 63 eine Traktionsbatterie 64 handeln, die z.B. bei einem batterieelektrischen Fahrzeug zur Anwendung kommt. Figur 14 zeigt demnach eine Anordnung 65 einer Traktionsbatterie 64 an einer Wärmeübertragerplatte 1. Auf diese Anordnung 65 wird weiter unten mit Bezug auf Figur 14 näher eingegangen.

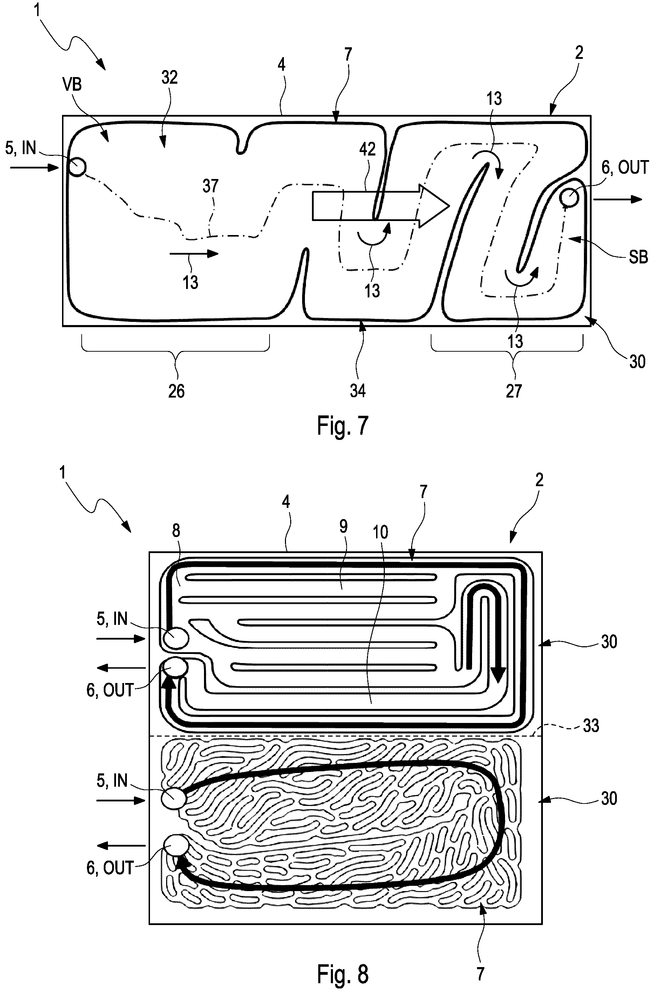

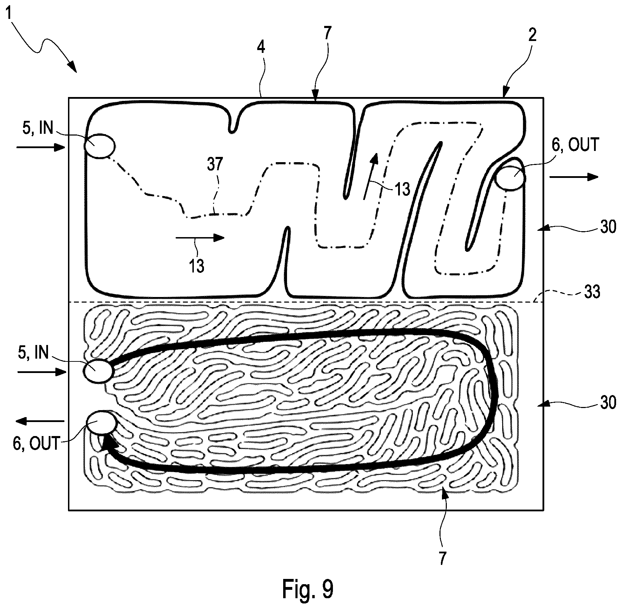

Der Plattenkörper 2 ist hier flach und eben konfiguriert und besitzt eine rechteckige Geometrie, wobei grundsätzlich auch andere Geometrien für den Plattenkörper 2 denkbar sind. Der Plattenkörper 2 besitzt einen umlaufenden Plattenrand 4 und weist innerhalb des Plattenrands 4 zumindest eine Temperierzone 30 auf. In den Beispielen der Figuren 1 bis 7 und 10 bis 14 weist der Plattenkörper 2 jeweils nur eine solche Temperierzone 30 auf. In den Beispielen der Figuren 8 und 9 weist der Plattenkörper 2 dagegen jeweils zwei solche Temperierzonen 30 auf. Es ist klar, dass der Plattenkörper 2 bei anderen Ausführungsformen auch drei oder mehr solche Temperierzonen 30 aufweisen kann. Die nachfolgend für eine Temperierzone 30 erläuterten Merkmale können gleichermaßen bei allen Temperierzonen 30 des Plattenkörpers 2 realisiert werden. Die jeweiligen Temperierzone 30 ist innerhalb des Plattenkörpers 2 nach außen durch einen Zonenrand 33 begrenzt. In den Beispielen der Figuren 1 bis 7 und 10 bis 14 fällt der Zonenrand 33 mit dem Plattenrand 4 zusammen. In den Beispielen der Figuren 8 und 9 fällt der jeweilige Zonenrand 33 teilweise mit dem Plattenrand 4 zusammen. Ferner ist ein Teil des Zonenrands 33 der einen Temperierzone 30 gleichzeitig einen Teil des Zonenrands 33 der anderen Temperierzone 30.

Die jeweilige Temperierzone 30 weist einen am Plattenkörper 2 ausgebildeten Zulauf IN mit mindestens einem Zulaufanschluss 5 zum Zuführen des Temperiermittels und einen am Plattenkörper 2 ausgebildeten Ablauf OUT mit mindestens einem Ablaufanschluss 6 zum Abführen des Temperiermittels auf. Die Zuführung des Temperiermittels und die Abführung des Temperiermittels ist dabei durch Pfeile angedeutet. Rein exemplarisch ist in Figur 14 eine Ausführungsform gezeigt, bei welcher der Zulauf IN zwei Zulaufanschlüsse 5 aufweist. In der jeweiligen Temperierzone 30 ist im Plattenkörper 2 ein Kanalsystem 7 ausgebildet, das zum Führen des Temperiermittels dient und das den Zulauf IN mit dem Ablauf OUT fluidisch verbindet.

Das Kanalsystem 7 kann gemäß den Beispielen der Figuren 1 bis 4 und 12 bis 14 zumindest zwei Verteilerkanäle 8 aufweisen, die mit dem Zulauf IN 5 fluidisch verbunden sind und die sich jeweils in mehrere gerade Verbindungskanäle 9 aufzweigen. Die Verbindungskanäle 9 verlaufen dabei zweckmäßig parallel zueinander. Das Kanalsystem 7 weist außerdem zumindest zwei Sammelkanäle 10 auf, die mit dem Ablauf OUT fluidisch verbunden sind und in die jeweils mehrere der Verbindungskanäle 9 einmünden.

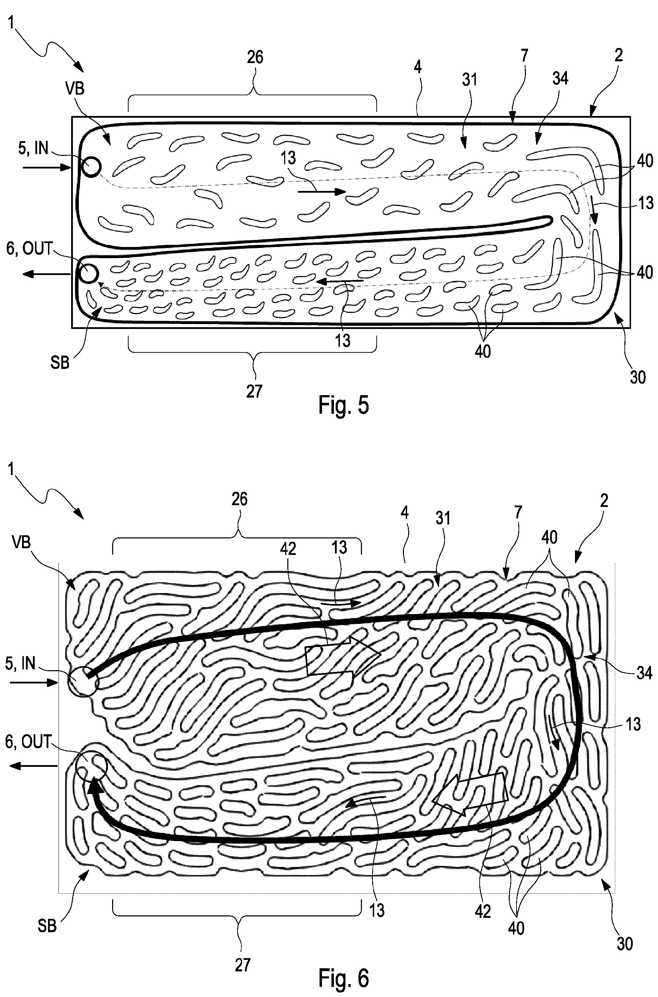

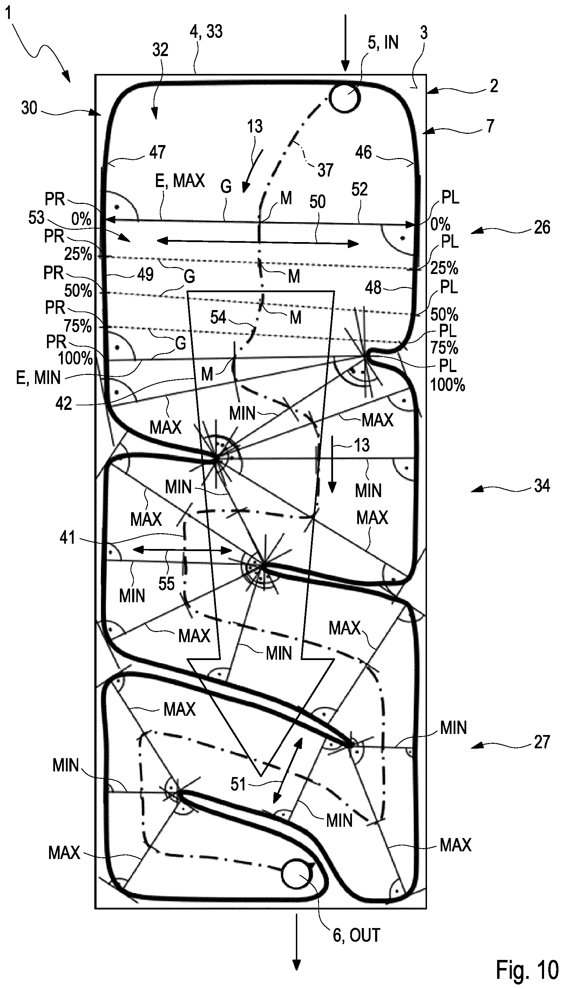

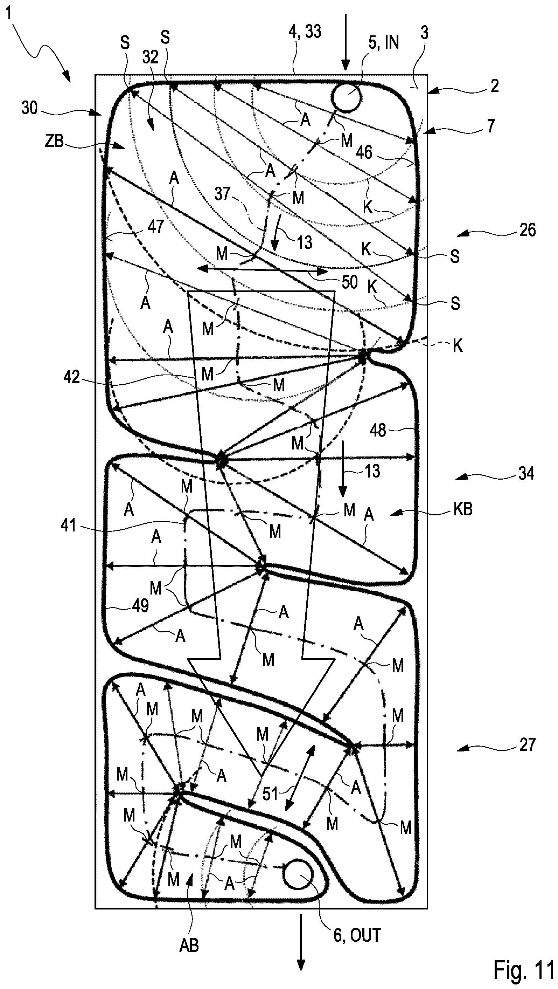

Im Unterschied dazu zeigen die Figuren 5, 6, 7, 10 und 11 jeweils ein Kanalsystem 7 mit nur einem einzigen Kanal 31, 32. In den Beispielen der Figuren 5 und 6 weist der Kanal 31 eine U-Konfiguration auf, so dass dieser Kanal 31 auch als U-Kanal 31 bezeichnet werden kann. Dabei führt ein Vorlaufbereich des U-Kanals 31 vom Zulauf IN 5 weg, in den Figuren 5 und 6 jeweils oben von links nach rechts, während ein Rücklaufbereich des U-Kanals 31 zum Ablauf OUT hinführt, in den Figuren 5 und 6 jeweils unten von rechts nach links. In den Beispielen der Figuren 7, 10 und 11 weist der Kanal 32 eine I-Konfiguration auf, so dass dieser Kanal 32 auch als I-Kanal 32 bezeichnet werden kann. Im Beispiel der Figuren 7, 10 und 11 führt der I-Kanal 32 mit mehreren Umlenkungen bzw. Schikanen vom Zulauf IN zum Ablauf OUT, in Figur 7 von links nach rechts und in den Figuren 10 und 11 von oben nach unten.

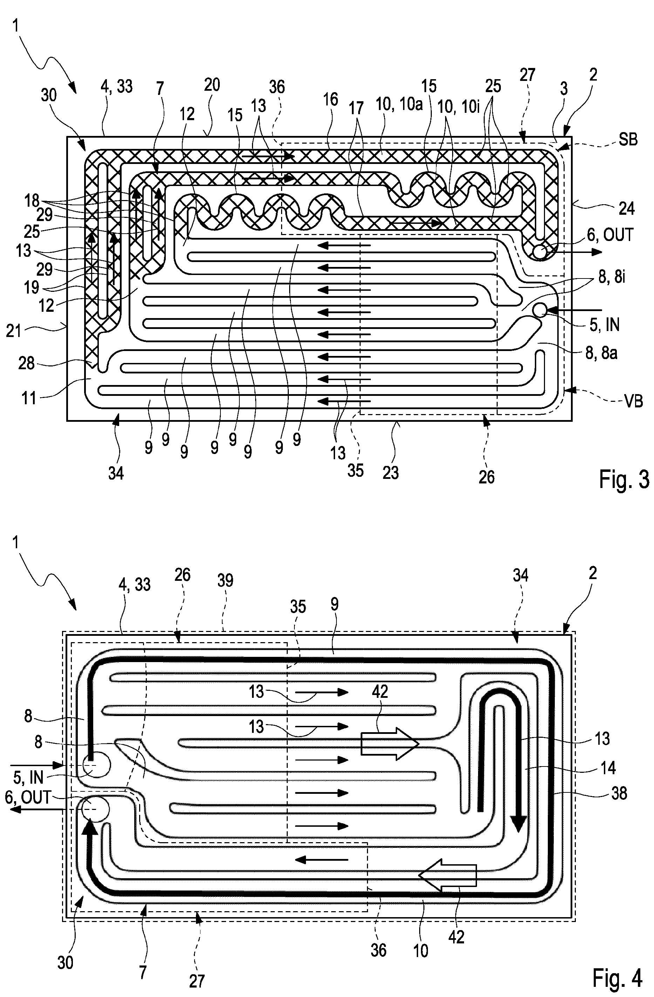

Die Verteilerkanäle 8 der Figuren 1 bis 4 und 12 bis 14 bilden zumindest einen inneren Verteilerkanal 8i und einen äußeren Verteilerkanal 8a. Der äußere Verteilerkanal 8a verläuft dabei näher am Plattenrand 4 bzw. Zonenrand 33 als der jeweilige innere Verteilerkanal 8i. Der äußere Verteilerkanal 8a ist zum Plattenrand 4 direkt benachbart, während der innere Verteilerkanal 8i zum Plattenrand 4 indirekt benachbart ist. Die Sammelkanäle 10 bilden einen inneren Sammelkanal 10i und einen äußeren Sammelkanal 10a, wobei der äußere Sammelkanal 10a näher am Plattenrand 4 verläuft als der innere Sammelkanal 10i. In den äußeren Sammelkanal 10a münden an einem Kanalanfang 11 des äußeren Sammelkanals 10a wenigstens zwei Verbindungskanäle 9 ein, die vom äußeren Verteilerkanal 8a abzweigen. In den Beispielen der Figuren 1, 2, 4 und 12 bis 14 sind es die beiden benachbart zum Plattenrand 4 angeordneten äußeren oder außenliegenden Verbindungskanäle 9. Im Beispiel der Figur 3 sind es die drei benachbart zum Plattenrand 4 angeordneten äußeren oder außenliegenden Verbindungskanäle 9. In den inneren Sammelkanal 10i münden an einem Kanalanfang 12 des inneren Sammelkanals 10i wenigstens zwei Verbindungskanäle 9 ein, die vom jeweiligen inneren Verteilerkanal 8i abzweigen. In den Beispielen der Figuren 1, 2, 4 und 12 bis 14 handelt es sich um die beiden zu den Sammelkanälen 10 benachbarten Verbindungskanäle 9. Im Beispiel der Figur 3 sind zwei innere Sammelkanäle 10i vorgesehen. In den zum äußeren Sammelkanal 10a benachbarten inneren Sammelkanal 10i münden drei Verbindungskanäle 9 ein, die zu den drei Verbindungskanälen 9 benachbart sind, die in den äußeren Sammelkanal 10a einmünden. In den anderen inneren Sammelkanal 10i münden die verbleibenden zwei Verbindungskanäle 9 ein, die zu diesem inneren Sammelkanal 10i benachbart sind.

Der jeweilige innere Sammelkanal 10i besitzt in einer in den Figuren durch Pfeile angedeuteten Strömungsrichtung 13 des Temperiermittels eine nicht näher bezeichnete Kanallänge, die am Kanalanfang 12 des jeweiligen inneren Sammelkanals 10i beginnt und am Auslassanschluss 6 endet. Der äußere Sammelkanal 10a besitzt in der Strömungsrichtung 13 des Temperiermittels eine nicht näher bezeichnete Kanallänge, die am Kanalanfang 11 des äußeren Sammelkanals 10 beginnt und am Auslassanschluss 6 endet. Der innere Sammelkanal 10i und der äußere Sammelkanal 10a verlaufen im Plattenkörper 2 derart, dass die Kanallänge des inneren Sammelkanals 10i mindestens 75 % von der Kanallänge des äußeren Sammelkanals 10a beträgt. Angestrebt ist, dass der innere Sammelkanal 10i nahezu die gleiche Kanallänge aufweist wie der äußere Sammelkanal 10a. Die Kanallänge des jeweiligen inneren Sammelkanals 10i kann daher auch mindestens 80 % oder mindestens 85 % oder mindestens 90 % oder mindestens 95 % oder etwa 100 % von der Kanallänge des äußeren Sammelkanals 10a betragen.

Der innere Sammelkanal 10i kann in den Beispielen der Figuren 1, 2, 4, 13 und 14 einen Schlaufenabschnitt 14 aufweisen, der die Kanallänge des inneren Sammelkanals 10i vergrößert. Im Beispiel der Figur 3 weist der jeweilige innere Sammelkanal 10i je einen Mäanderabschnitt 15 auf.

Der jeweilige innere Sammelkanal 10i und der äußere Sammelkanal 10a weisen jeweils zwei Längsabschnitte 16, 17, 18, 19 auf, in denen der innere Sammelkanal 10i und der äußere Sammelkanal 10a parallel zu benachbarten Längsabschnitten 20, 21 des Plattenrands 4 verlaufen. In den Figuren 1 bis 4 besitzt der äußere Sammelkanal 10a oben einen Längsabschnitt 16, der parallel zum oberen Längsabschnitt 20 des Plattenrands 4 verläuft. Der äußere Sammelkanal 10a weist außerdem in den Figuren 1 bis 4, 13 und 14 einen links zu sehenden Längsabschnitt 19 auf, der parallel zum benachbarten linken Längsabschnitt 21 des Plattenrands 4 verläuft. Der jeweilige innere Sammelkanal 10i besitzt in den Figuren 1 bis 4, 13 und 14 oben einen Längsabschnitt 17, der parallel zum oberen Längsabschnitt 20 des Plattenrands 4 verläuft, sowie links einen Längsabschnitt 18, der parallel zum linken Längsabschnitt 21 des Plattenrands 4 verläuft.

In den Beispielen der Figuren 1, 2, 4, 13 und 14 ist vorgesehen, dass ein von einem der inneren Verteilerkanäle 8i abzweigender Verbindungskanal 9 in den äußeren Sammelkanal 10a einmündet. In den Figuren 1, 2, 4, 13 und 14 handelt es sich dabei um den dritten Verbindungskanal 9 von unten. Dieser zweigt bei einem Kanalende 22 des einen inneren Verteilerkanal 8i ab und mündet am Kanalanfang 11 des äußeren Sammelkanals 10a in diesen äußeren Sammelkanal 10a ein. Der andere Verbindungskanal 9, der am Kanalende 22 dieses Verteilerkanal 8i abzweigt, mündet am Kanalanfang 12 in den inneren Sammelkanal 10i ein.

Da der Plattenkörper 2 hier rechteckig konfiguriert ist, besitzt der Plattenrand 4 zwei längere Längsabschnitte 20 und 23, die in den Figuren 1 bis 7, 13 und 14 horizontal verlaufen, sowie zwei kürzere Längsabschnitte 21 und 24, die in den Figuren 1 bis 7, 13 und 14 vertikal verlaufen. Die längeren Längsabschnitte 20 und 23 verlaufen parallel zueinander und senkrecht zu den beiden kürzeren Längsabschnitten 21, 24, die ihrerseits parallel zueinander verlaufen. Die längeren Längsabschnitte 20, 23 erstrecken sich dabei parallel zu den Verbindungskanälen 9. Dementsprechend verlaufen auch die Längsabschnitte 16 und 17 der Sammelkanäle 10 parallel zu den Verbindungskanälen 9. Entsprechendes gilt auch für die Ausführungsformen der Figuren 8 und 9, bei denen der Plattenkörper 2 zwei Temperierzonen 30 aufweist, wobei sich die Längsabschnitte dann auf die rechteckige Temperierzone 30 bzw. auf deren Zonenrand 33 beziehen.

Gemäß einer vorteilhaften Ausführungsform ist das Kanalsystem 7 so konfiguriert, dass die Verteilerkanäle 8 einen kleineren Wärmeübertragungskoeffizienten aufweisen als die Sammelkanäle 10 und/oder als die Verbindungskanäle 9. Insbesondere kann vorgesehen sein, dass die Sammelkanäle 10 einen größeren Wärmeübergangskoeffizienten aufweisen als die Verbindungskanäle 9. Dies kann durch unterschiedliche Maßnahmen realisiert werden. Die nachfolgend genannten Maßnahmen können dabei jeweils einzeln oder kumuliert oder in beliebiger Kombination realisiert werden. Beispielsweise kann der durchströmbare Querschnitt des jeweiligen Sammelkanals 10 kleiner sein als die Summe der durchströmbaren Querschnitte der darin einmündenden Verbindungskanäle 9. Da in den Figuren 1 bis 3 eine in der Ebene des Plattenkörper 2 und quer zur Luftströmungsrichtung 13 gemessene Breite des jeweiligen Kanals im Wesentlichen konstant ist, lässt sich der durchströmbare Querschnitt des jeweiligen Kanals insbesondere durch eine senkrecht zur Ebene des Plattenkörper 2 gemessene Kanalhöhe bestimmen. Außerdem wird der durchströmbare Querschnitt durch gegebenenfalls in den Kanälen angeordnete Wärmeleitelemente reduziert. In den Beispielen der Figuren 1 und 2 münden jeweils drei Verbindungskanäle 9 in den jeweiligen Sammelkanal 10 ein. Im Beispiel der Figur 3 münden in den einen inneren Sammelkanal 10i zwei Verbindungskanäle 9 ein, während in den anderen inneren Sammelkanal 10i und in den äußeren Sammelkanal 10a jeweils drei Verbindungskanäle 9 einmünden. Damit lässt sich der durchströmbare Querschnitt des jeweiligen Sammelkanals 10 relativ einfach kleiner ausgestalten als die Summe der durchströmbaren Querschnitte der darin einmündenden Verbindungskanäle 9. Zusätzlich oder alternativ kann vorgesehen sein, dass ein Durchströmungswiderstand im jeweiligen Sammelkanal 10 größer ist als in den darin einmündenden Verbindungskanälen 9. Zusätzlich oder alternativ können in den Sammelkanälen 10 Wärmeleitelemente 25 angeordnet oder ausgebildet sein, die in den Figuren durch Schraffuren angedeutet sind. Die Wärmeleitelemente 25 sind so konfiguriert, dass sie die Wärmeübertragung zwischen dem Temperiermittel und dem Plattenkörper 2 verbessern. Die Wärmeleitelemente 25 können hierzu aus einem wärmeleitenden Material, vorzugsweise aus einem Metall, bestehen und besitzen eine dem Temperiermittel ausgesetzte Oberfläche und stehen zweckmäßig direkt mit dem Plattenkörper 2 in Kontakt. Die Wärmeleitelemente 25 können als Turbulatoren oder Rippen oder Lamellen konfiguriert sein oder durch eine Kombination daraus gebildet sein. Die Wärmeleitelemente 25 können separate Komponenten sein, die in die Sammelkanäle 10 eingesetzt sind, oder integral bzw. einstückig am Plattenkörper ausgeformt sein. Im Unterschied dazu kann vorgesehen sein, dass die Verbindungskanäle 9 keine derartigen Wärmeleitelemente 25 enthalten. Sofern jedoch in den Sammelkanälen 10 und in den Verbindungskanälen 9 Wärmeleitelemente 25 angeordnet sind, ist zweckmäßig vorgesehen, dass die Wärmeleitelemente 25, die in den Sammelkanälen 10 angeordnet sind, eine größere Anzahl und/oder eine größere Anordnungsdichte und/oder eine größere dem Temperiermittel ausgesetzte Oberfläche und/oder eine größere Wärmeleitfähigkeit aufweisen als die Wärmeleitelemente, die in den Verbindungskanälen 9 angeordnet sind.

Das Kanalsystem 7 besitzt vom Zulauf IN bis zum Ablauf OUT eine nur in den Figuren 10, 11, 13 und 14 bezeichnete Kanalsystemgesamtlänge 41. Das Kanalsystem 7 besitzt einen Eintrittsbereich 26, der in den Figuren 1 bis 3 durch eine unterbrochene Linie und in den Figuren 5 bis 7 durch eine geschweifte Klammer angedeutet ist und der sich über 20% bis 40%, vorzugsweise über 25% bis 35% der Kanalsystemgesamtlänge 41 erstreckt. Das Kanalsystem 7 weist außerdem einen Austrittsbereich 27 auf, der in den Figuren 1 bis 3 mit einer unterbrochenen Linie und in den Figuren 5 bis 7 mit einer geschweiften Klammer angedeutet ist und der sich über 20% bis 40%, vorzugsweise über 25% bis 35% der Kanalsystemgesamtlänge 41 erstreckt. Ein Verbindungsbereich 34 des Kanalsystems 7 verbindet den Eintrittsbereich 26 mit dem Austrittsbereich 27.

Eine Anzahl an Kanälen im Austrittsbereich 27 liegt im Bereich von 20 % bis 70 % von einer Anzahl an Kanälen im Eintrittsbereich 26. In den Beispielen der Figuren 1, 2, 4, 13 und 14 liegen im Austrittsbereich 26 jeweils zwei Kanäle, nämlich die beiden Sammelkanäle 10, während im Eintrittsbereich 27 sechs Verbindungskanäle 9 liegen. Im Beispiel der Figur 3 sind drei Sammelkanäle 10 im Austrittsbereich 27 angeordnet, während sich im Eintrittsbereich 26 acht Verbindungskanäle 9 befinden. Insbesondere ist die Anzahl der Verbindungskanäle 9 mindestens doppelt so groß oder mehr als doppelt so groß wie eine Anzahl an Sammelkanälen 10. In den Figuren 1, 2, 4, 13 und 14 treffen sechs Verbindungskanäle 9 auf zwei Sammelkanäle 10. Im Beispiel der Figur 3 treffen acht Verbindungskanäle 9 auf drei Sammelkanäle 10.

Bei den in den Figuren 1 bis 6 und 12 bis 14 gezeigten, bevorzugten Ausführungsformen sind der Zulauf IN und Ablauf OUT am Plattenkörper 2 nebeneinander angeordnet, und zwar im Bereich eines Längsendes des Plattenkörper 2 bzw. in der Nähe des Plattenrands 4. Hierdurch ergibt sich eine U-Konfiguration. Der äußere Verteilerkanal 8a, der zum Plattenrand 4 bzw. zum Zonenrand 33 benachbarte Verbindungskanal 9, also der in den Figuren 1 bis 3 unterste Verbindungskanal 9, und der äußere Sammelkanal 10a bilden in Kanalsystem 7 einen Randkanal 28, der entlang des Plattenrands 4 umläuft und den Zulauf IN mit dem Ablauf OUT fluidisch verbindet.

In den Beispielen der Figuren 2, 4, 13 und 14 ist die Schlaufe im Schlaufenabschnitt 14 stärker ausgeprägt bzw. länger ausgestaltet als im Beispiel der Figur 1. Damit geht in den Beispielen der Figuren 2, 4, 13 und 14 auch eine Verkürzung der Verbindungskanäle 9 einher, die vom äußeren Verteilerkanal 8a abzweigen.

Im Beispiel der Figur 3 sind zwei innere Sammelkanäle 10i vorgesehen. In den einen inneren Sammelkanal 10i münden drei Verbindungskanäle 9 ein. In den anderen innere Sammelkanal 10i münden zwei Verbindungskanäle 9 ein. In den äußeren Sammelkanal 10a münden drei Verbindungskanäle 9 ein. Der äußere Sammelkanal 10a und der dazu benachbarte innere Sammelkanal 10i weisen in einem Bereich, der dem in Figur 3 linken Längsabschnitt 21 des Plattenrands 4 zugewandt ist, jeweils zwei parallel zu diesem Längsabschnitt 21 des Plattenrands 4 verlaufende Längsabschnitte 18 bzw. 19 auf. Hierzu weist der jeweilige Sammelkanal 10 in diesem Bereich jeweils einen Parallelkanal 29 auf, der innerhalb des jeweiligen Sammelkanals 10 abzweigt und wieder einmündet.

Bei der hier vorgestellten Wärmeübertragerplatte 1 ist das jeweiligen Kanalsystem 7 so konfiguriert, dass ein durchströmbarer Querschnitt des Kanalsystems 7 in dem vom Zulauf IN wegführenden Eintrittsbereich 26 größer ist als in dem zum Ablauf OUT hinführenden Austrittsbereich 27. Zur Homogenisierung der Wärmeübertragungsleistung entlang des Kanalsystems 7 kann die reduzierte Temperaturdifferenz im Austrittsbereich 27 durch die höhere Strömungsgeschwindigkeit im Austrittsbereich 27 weitgehend kompensiert werden.

Bevorzugt weist das Kanalsystem 7 vom Zulauf IN bis zum Ablauf OUT die Kanalsystemgesamtlänge 41 auf, wobei das Kanalsystem 7 den Eintrittsbereich 26, der sich über etwa 1/3 der Kanalsystemgesamtlänge 41 erstreckt, den Austrittsbereich 27, der sich über etwa 1/3 der Kanalsystemgesamtlänge 41 erstreckt, und den Verbindungsbereich 34 aufweist, der den Eintrittsbereich 26 mit dem Austrittsbereich 27 verbindet und ebenfalls etwa 1/3 der Kanalsystemgesamtlänge 41 betragen kann. Außerdem kann vorgesehen sein, dass ein durchströmbarer Querschnitt des Eintrittsbereichs 26 an seinem Übergang 35 zum Verbindungsbereich 34 mindestens 50% größer ist als ein durchströmbarer Querschnitt des Austrittsbereichs 27 an seinem Übergang 36 zum Verbindungsbereich 34.

Zweckmäßig nimmt dabei der durchströmbare Querschnitt ausgehend vom Zulauf IN zu und nimmt dann entlang des Eintrittsbereichs 26, des Verbindungsbereichs 34 und des Austrittsbereich 27 bis zum Ablauf OUT 27 im Wesentlichen nur noch ab.

Vorteilhaft kann vorgesehen sein, dass der durchströmbare Querschnitt des Eintrittsbereichs 26 an seinem Übergang 35 zum Verbindungsbereich 34 in einem Bereich von 70% bis 600%, vorzugsweise in einem Bereich von 100% bis 400%, des durchströmbaren Querschnitts des Austrittsbereichs 27 an seinem Übergang 36 zum Verbindungsbereich 34 liegt, jeweils einschließlich der Bereichsgrenzen.

Gemäß einer Ausführungsform kann ferner vorgesehen sein, dass ein mittlerer durchströmbarer Querschnitt der im Eintrittsbereich 26 verlaufenden Kanäle 8, 9, 31, 32 mindestens 50% größer ist als ein mittlerer durchströmbarer Querschnitt der im Austrittsbereich 27 verlaufenden Kanäle 9,10, 31, 32. Insbesondere kann vorgesehen sein, dass der mittlere durchströmbare Querschnitt der im Eintrittsbereich 26 verlaufenden Kanäle 8, 9, 31, 32 in einem Bereich von 70% bis 600%, vorzugsweise in einem Bereich von 100% bis 400%, des mittleren durchströmbaren Querschnitts der im Austrittsbereich 27 verlaufenden Kanäle 9, 10, 31, 32 liegt.

Optional kann vorgesehen sein, dass der mittlere durchströmbare Querschnitt der Kanäle 8, 9, 31, 32 des Eintrittsbereichs 26 über die Länge des Eintrittsbereichs 26 gemittelt ist und/oder dass der mittlere durchströmbare Querschnitt der Kanäle 9, 10, 31, 32 des Austrittsbereichs 27 über die Länge des Austrittsbereichs 27 gemittelt ist. Insbesondere kann dabei vorgesehen sein, dass der mittlere durchströmbare Querschnitt der Kanäle 8, 9, 31, 32 des Eintrittsbereichs 26 über die effektive Länge des Eintrittsbereichs 26 gemittelt ist und/oder dass der mittlere durchströmbare Querschnitt der Kanäle 9, 10, 31, 32 des Austrittsbereichs 27 über die effektive Länge des Austrittsbereichs 27 gemittelt ist.

Die effektive Länge kann bei einem geraden Kanalabschnitt durch den Abstand vom Einlass bis zum Auslass des geraden Kanalabschnitts gebildet sein. Die effektive Länge kann bei einem quer zur einer Hauptströmungsrichtung 42 gewellten Kanalabschnitt durch den in der Hauptströmungsrichtung 42 gemessenen Abstand vom Einlass bis zum Auslass des quer zur Hauptströmungsrichtung 42 gewellten Kanalabschnitts gebildet sein. Die effektive Länge kann bei einem schlaufenförmigen Kanalabschnitt, der zwei gerade Kanalabschnitte, einen um 180° gebogenen Kanalabschnitt, welcher die beiden geraden Kanalabschnitte miteinander verbindet, und zwei um 90° gebogene Kanalabschnitte aufweisen, welche den jeweiligen geraden Kanalabschnitt mit einem Einlass bzw. mit einem Auslass des schlaufenförmigen Kanalabschnitts verbinden, durch die Summe der Längen der beiden geraden Kanalabschnitte gebildet sein. Die effektive Länge kann bei einem schlaufenförmigen Kanalabschnitt, der drei gerade Kanalabschnitte und zwei um 180° gebogene Kanalabschnitte aufweist, welche je zwei der geraden Kanalabschnitte miteinander verbinden, durch den Abstand vom Einlass des ersten geraden Kanalabschnitts, der über den ersten gebogenen Kanalabschnitt mit dem zweiten geraden Kanalabschnitt verbunden ist, bis zum Auslass des dritten geraden Kanalabschnitts gebildet sein, der über den zweiten gebogenen Kanalabschnitt mit dem zweiten geraden Kanalabschnitt verbunden ist.

Der durchströmbare Querschnitt des jeweiligen Kanals ergibt sich im Wesentlichen aus der senkrecht zur Plattenebene gemessenen Kanalhöhe und der quer zur Kanalhöhe gemessenen Kanalbreite. Der dabei zu berücksichtigende Querschnitt erstreckt sich senkrecht zu einer in den Figuren 7, 10, 11, 13 und 14 eingetragenen neutralen Faser oder Mittellinie 37 des jeweiligen Kanals. Bei einem Kanal mit im Wesentlichen gerade verlaufenden seitlichen Kanalbegrenzungen entspricht die Mittellinie 37 der Hälfte des Abstands zwischen den seitlichen Kanalbegrenzungen. Sofern jedoch keine geraden seitlichen Kanalbegrenzungen vorliegen, ist die Ermittlung der neutralen Mittellinie 37 und damit die Ermittlung des zu berücksichtigenden Querschnitts vergleichsweise komplex. Grundsätzlich können Strömungssimulationen herangezogen werden, um die Mittellinie 37 und damit die zu berücksichtigenden durchströmbaren Querschnitte zu bestimmen.

Der durchströmbare Querschnitt beschreibt die dem Temperiermittel zur Verfügung stehende lichte Öffnungsweite, also der sich aus der Breite und der Höhe ergebende Öffnungsquerschnitt abzüglich Noppen, Sicken und anderen Konturierungen. Für jede Stelle des Kanalsystems 7 wird die Kanalbreite als Schnitt durch das Kanalsystem 7 bestimmt. Der durchströmbare Querschnitt des Kanals ist der dem Temperiermittel zur Verfügung stehende Öffnungsquerschnitt in diesem Schnitt. Als Kanallänge des Kanalsystems bzw. im Eintrittsbereich, im Verbindungsbereich und im Austrittsbereich gilt bevorzugt die Länge der Mittellinie 37 im jeweiligen Kanalbereich. Auf Möglichkeiten zur Ermittlung der Kanalsystemgesamtlänge 41 wird weiter unten mit Bezug auf die Figuren 10, 11, 13 und 14 noch näher eingegangen.

Das Kanalsystem 7 kann einen Außenpfad 38 aufweist, der hier stellvertretend für alle in den Figuren 1 bis 14 gezeigten Ausführungsformen nur in Figur 4 bezeichnet ist. Dieser Außenpfad 38 ist durch einen der Verteilerkanäle 8, einen der Verbindungskanäle 9 und einen der Sammelkanäle 10 gebildet und erstreckt sich entlang eines Zonenrands 33 der Temperierzone 30. Dabei ist der Außenpfad 38 maximal 30% länger ist als ein kürzester Verbindungsweg 39, der stellvertretend in Figur 4 durch eine unterbrochene Linie angedeutet ist. Dieser kürzeste Verbindungsweg 39 führt dabei vom Zulauf IN direkt, also auf dem kürzesten Weg zum Zonenrand 33, entlang des Zonenrands 33 und entlang des Außenpfads 38 und vom Zonenrand 33 direkt, auf dem kürzesten Weg zum Ablauf OUT. Typischerweise kann ein solcher Außenpfad 38 den längsten Pfad innerhalb des jeweiligen Temperierzone 30 bilden. Durch die hier vorgestellte Maßnahme wird erreicht, dass dieser längste Pfad möglichst kurz ausgestaltet ist, nämlich maximal 30% länger als der entlang des Zonenrands 33 zum Verbinden des Zulaufs IN mit dem Ablauf OUT mögliche kürzeste Pfad 39.

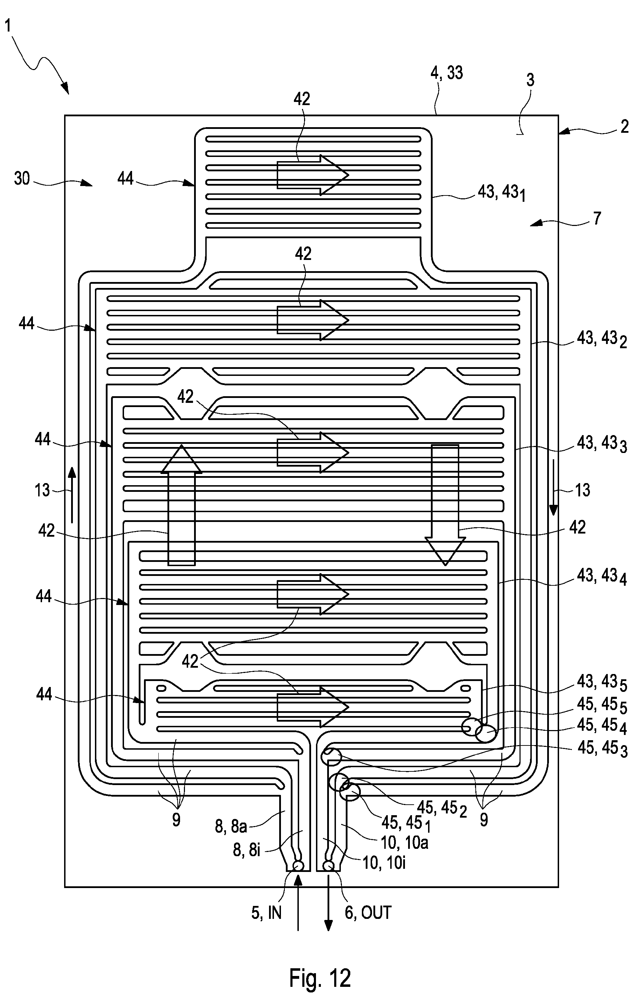

Das Kanalsystem 7 kann gemäß Figur 12 mehrere Pfade 43 aufweisen, die jeweils das Temperiermittel vom Zulauf IN durch einen der Verteilerkanäle 8, einen der Verbindungskanäle 9 und einen der Sammelkanäle 10 zum Ablauf OUT führen und jeweils eine Pfadlänge aufweisen. Diese Pfade 43 können unterschiedliche Pfadlängen aufweisen. Im Beispiel der Figur 12 sind fünf Pfade 43 vorgesehen, die jeweils eine Parallelzone 44 mit mehreren parallel durchströmten und parallel verlaufenden, nicht näher bezeichneten Kanälen aufweisen. Die fünf Pfade 43 bilden einen ersten Pfad 43₁, einen zweiten Pfad 43₂, der kürzer ist als der erste Pfad 43₁, einen dritten Pfad 43s, der kürzer ist als der zweite Pfad 43₂, einen vierten Pfad 43₄, der kürzer ist als der dritte Pfad 43s, und einen fünften Pfad 43s, der kürzer ist als der vierte Pfad 43₄. In der Parallelzone 44 des ersten Pfads 43₁ variiert die Pfadlänge im gezeigten Beispiel von 93% bis 100%. In der Parallelzone 44 des zweiten Pfads 43₂ variiert die Pfadlänge im gezeigten Beispiel von 63% bis 67%. In der Parallelzone 44 des dritten Pfads 43s variiert die Pfadlänge im gezeigten Beispiel von 51% bis 59%. In der Parallelzone 44 des vierten Pfads 43₄ variiert die Pfadlänge im gezeigten Beispiel von 38% bis 46%. In der Parallelzone 44 des fünften Pfads 43s liegt die Pfadlänge im gezeigten Beispiel bei etwa 33%. Die Prozentangaben beziehen sich dabei auf den längsten Pfad 43, der im ersten Pfad 43₁ durch den am weitesten außenliegenden Kanal in der Parallelzone 44 definiert ist und damit die 100% bestimmt.

Der Pfad 43, der die größte Pfadlänge besitzt, definiert den längsten Pfad. Im Beispiel der Figur 12 besitzt der erste Pfad 43₁ die größte Pfadlänge. Bei einer vorteilhaften Ausführungsform ist vorgesehen, dass jeder Pfad 43, dessen Pfadlänge kleiner ist als 50% (Fall A), insbesondere kleiner ist als 60% (Fall B), vorzugsweise kleiner ist als 75% (Fall C), der Pfadlänge des längsten Pfads 43₁, einen kurzen Pfad bildet. Im Fall A bilden der fünfte Pfad 43s und der vierte Pfad 43₄ jeweils einen kurzen Pfad 43. Im Fall B bilden der fünfte Pfad 43s, der vierte Pfad 43₄ und der dritte Pfad 43s jeweils einen kurzen Pfad 43. Im Fall C bilden der fünfte Pfad 43s, der vierte Pfad 43₄, der dritte Pfad 43₃ und der zweite Pfad 43₂ jeweils einen kurzen Pfad 43.

In Figur 12 ist für jeden Pfad 43 eine Position mit einem Kreis markiert, die innerhalb des jeweiligen Pfads 43 den kleinsten durchströmbaren Querschnitt 45. Markiert sind hier exemplarisch auf der Abströmseite der jeweiligen Parallelzone 44 Der kleinste durchströmbare Querschnitt 45₁ des ersten Pfads 43₁, der kleinste durchströmbare Querschnitt 45₂ des zweiten Pfads 43₂, der kleinste durchströmbare Querschnitt 45s des dritten Pfads 43s, der kleinste durchströmbare Querschnitt 45₄ des vierten Pfads 43₄ und der kleinste durchströmbare Querschnitt 45s des fünften Pfads 43s.

Bevorzugt ist eine Konfiguration des Kanalsystems 7, bei der die Summe der kleinsten durchströmbaren Querschnitte 45 aller kurzen Pfade 43 kleiner ist als 40%, insbesondere kleiner ist als 20%, vorzugsweise kleiner ist als 10%, der Summe der kleinsten durchströmbaren Querschnitte 45 aller anderen Pfade 43. Dabei beinhalten "alle anderen Pfade 43" zumindest den längsten Pfad 43₁ und - falls vorhanden - jeden weiteren Pfad 43, der nicht als kurzer Pfad 43 gilt.

Im Fall A, bei dem die Pfadlänge der kurzen Pfade 43 kleiner ist als 50% der Pfadlänge des längsten Pfads 43₁, beinhalten "alle anderen Pfade 43" den längsten Pfad 43₁ und jeden weiteren Pfad 43, dessen Pfadlänge größer ist als 50% der Pfadlänge des längsten Pfads 43₁, also den dritten Pfad 43₃ und den zweiten Pfad 43₂. Im Fall B, bei dem die Pfadlänge der kurzen Pfade 43 kleiner ist als 60% der Pfadlänge des längsten Pfads 43₁, beinhalten die anderen Pfade 43 jeden Pfad 43, dessen Pfadlänge größer ist als 60% der Pfadlänge des längsten Pfads 43₁, also den zweiten Pfad 43₂. Im Fall C, bei dem die Pfadlänge der kurzen Pfade 43 kleiner ist als 75% der Pfadlänge des längsten Pfads 431, beinhalten die anderen Pfade jeden Pfad, dessen Pfadlänge größer ist als 75% der Pfadlänge des längsten Pfads 43₁, also keinen weiteren Pfad 43 zusätzlich zum längsten bzw. ersten Pfad 43₁.

Diese weiteren oder anderen Pfade 43 können auch als lange Pfade 43 aufgefasst werden. Sofern zwei oder mehr Pfade 43 mit gleicher Pfadlänge existieren, die länger bzw. größer ist als die Pfadlänge aller anderen Pfade 43, kann einer dieser Pfade 43 den längsten Pfad 43 bilden, während der oder die anderen dieser Pfade 43 dann jeweils einen langen Pfad 43 bzw. einen der weiteren Pfade 43 bilden.

Während die Figuren 1 bis 6 und 12 bis 14 Beispiele für Kanalsysteme 7 mit U-Konfiguration zeigen, zeigen die Figuren 7, 10 und 11 Varianten, bei der das Kanalsystem 7 eine I-Konfiguration aufweist. Hierbei sind der Zulauf IN und der Ablauf OUT an voneinander abgewandten Endabschnitten des Plattenkörpers 2 am Plattenkörper 2 angeordnet. Bei den Figuren 1 bis 4 und 12 bis 14 besitzt das Kanalsystem 7 jeweils mehrere Kanäle, nämlich mehrere Verteilerkanäle 8, mehrere Verbindungskanäle 9 und mehrere Sammelkanäle 10. Im Unterschied dazu weist das Kanalsystem 7 bei den Figuren 5 bis 7, 10 und 11 jeweils nur einen einzigen Kanal 31, 32 auf. Diese Kanäle 31, 32 können dabei mäandrierend konfiguriert sein, also einen mäanderförmigen Verlauf aufweisen, um den Zulauf IN mit dem Ablauf OUT zu verbinden.

Bei den Ausführungsformen der Figuren 5 und 6 weist der U-Kanal 31 eine Vielzahl separater, ungleicher und asymmetrisch verteilter und vom Temperiermittel umströmbarer Konturen 40 zur Strömungsführung und Wärmeübertragung auf. Im Beispiel der Figur 5 ist die Anzahl und Dichte der Konturen 40 kleiner als im Beispiel der Figur 6. Bei beiden Ausführungsformen ist vorgesehen, dass sich die im Austrittsbereich 27 ausgebildeten Konturen 40 durch eine größere Anordnungsdichte und/oder durch kleinere Abstände voneinander und/oder durch kleinere Abmessungen von den im Eintrittsbereich 26 angeordneten Konturen 40 unterscheiden.

Die Figuren 1 bis 7 und 10 bis 14 zeigen jeweils Konfigurationen der Wärmeübertragerplatte 1, bei welcher der Plattenkörper 2 nur eine einzige Temperierzone 30 aufweist. Im Unterschied dazu zeigen die Figuren 8 und 9 zwei Beispiele für Ausführungsformen, bei denen der Plattenkörper 2 innerhalb des Plattenrands 4 zwei derartige Temperierzonen 30 aufweist. Die beiden Temperierzonen 30 sind in den Darstellungen der Figuren 8 und 9 übereinander angeordnet. Die beiden Temperierzonen 30 weisen jeweils einen am Plattenkörper 2 ausgebildeten Zulauf IN zum Zuführen des Temperiermittels, einen am Plattenkörper 2 ausgebildeten Ablauf OUT zum Abführen des Temperiermittels und ein im Plattenkörper 2 ausgebildetes Kanalsystem 7 zum Führen des Temperiermittels auf, das den Zulauf IN mit dem Ablauf OUT fluidisch verbindet. Damit weist der Plattenkörper 2 zwei separate Zuläufe IN, zwei separate Ablauf OUT und zwei separate Kanalsysteme 7 auf. Zweckmäßig kann nun vorgesehen sein, dass die beiden Temperierzonen 30 hinsichtlich des jeweiligen Zulaufs IN, des jeweiligen Ablaufs OUT und des jeweiligen Kanalsystems 7 unterschiedlich ausgestaltet sind. In Figur 8 ist die obere Temperierzone 30 ausgestaltet wie die in den Figuren 4, 13 und 14 gezeigte Temperierzone 30, während die untere Temperierzone 30 ausgestaltet ist wie die in Figur 6 gezeigte Temperierzone 30. In Figur 9 ist dagegen die obere Temperierzone 30 ausgestaltet wie die in Figur 7, 10 und 11 gezeigte Temperierzone 30, während die untere Temperierzone 30 wieder ausgestaltet ist wie die in Figur 6 gezeigte Temperierzone 30.

Gemäß den Figuren 1 bis 14 definiert das Kanalsystem 7 für das im Kanalsystem 7 vom Zulauf IN zum Ablauf OUT strömende Temperiermittel eine Hauptströmungsrichtung 42, die durch einen oder mehrere Pfeile angedeutet ist. Das Kanalsystem 7 weist der Hauptströmungsrichtung 42 eine linke Kanalbegrenzungskontur 46 und eine rechte Kanalbegrenzungskontur 47 auf, die stellvertretend für alle Ausführungsformen nur in den Figuren 10 und 11 sowie 13 und 14 mit Bezugszeichen versehen sind. In den Figuren 10 und 11 ist die Hauptströmungsrichtung 42 von oben nach unten orientiert, so dass sich die linke Kanalbegrenzungskontur 46 in den Figuren 10 und 11 auf der rechten Seite befindet, während sich die rechte Kanalbegrenzungskontur 47 in den Figuren 10 und 11 auf der linken Seite befindet. Die beiden Kanalbegrenzungskonturen 46, 47 begrenzen einen dem Temperiermittel zur Durchströmung zur Verfügung stehenden Querschnitt des Kanalsystems 7 quer zur Hauptströmungsrichtung 42. Wenn man zu Erläuterungszwecken das Kanalsystem 7 als Flussbett betrachtet, dann bilden die linke Kanalbegrenzungskontur 46 und die rechte Kanalbegrenzungskontur 47 ein linkes Ufer und ein rechtes Ufer des Flussbetts.

Das Kanalsystem 7 definiert einen linken Mindestweg 48, der vom Zulauf IN entlang der linken Kanalbegrenzungskontur 46 zum Ablauf OUT führt, und einen rechten Mindestweg 49, der vom Zulauf IN entlang der rechten Kanalbegrenzungskontur 47 zum Ablauf OUT führt. Dabei werden bei der Ermittlung des jeweiligen Mindestwegs 48, 49 für die Verbindung vom Zulauf IN bzw. vom Ablauf OUT zur jeweiligen Kanalbegrenzungskontur 46, 47 jeweils der kürzeste, direkte Weg berücksichtigt.

Bei einem Zulauf IN mit nur einem Zulaufanschluss 5 wird die geometrische Mitte des Zulaufanschlusses 5 als Startpunkt der Mittellinie 37 verwendet. Bei einem Zulauf IN, der gemäß Figur 14 mehrere Zulaufanschlüsse 5 aufweist, wird die geometrische Mitte einer die Zulaufanschlüsse 5 umhüllenden Hüllkurve 56, die sogenannte "Umhüllende", als Startpunkt der Mittellinie 37 verwendet. Entsprechendes gilt dann auch für den Ablauf OUT, wenn dieser nur einem Ablaufanschluss 6 oder mehrere Ablaufanschlüsse 6 aufweist.

Das Kanalsystem 7 weist vom Zulauf IN bis zum Ablauf OUT die weiter oben bereits genannte Kanalsystemgesamtlänge 41 auf. Das Kanalsystem ist ferner so konfiguriert, dass die Kanalsystemgesamtlänge 41 maximal 50% oder maximal 40% oder maximal 30% oder maximal 25% oder maximal 20% oder maximal 15% oder maximal 10% oder maximal 5% oder maximal 0% größer ist als der größere Weg von linkem Mindestweg 48 und rechtem Mindestweg 49, wenn die beiden Mindestwege 48, 39 unterschiedlich groß sind, oder maximal 50% oder maximal 40% oder maximal 30% oder maximal 25% oder maximal 20% oder maximal 15% oder maximal 10% oder maximal 5% oder maximal 0% größer ist als der linke Mindestweg 48 oder als der rechte Mindestweg 49, wenn der linke Mindestweg 48 und der rechte Mindestweg 49 gleich groß sind. In den Beispielen der Figuren 10 und 11 ist der rechte Mindestweg 49 größer als der linke Mindestweg 48. Ebenso kann gemäß besonders vorteilhaften Ausführungsformen vorgesehen sein, dass die Konfiguration des Kanalsystems 7 so gewählt ist, dass die Kanalsystemgesamtlänge 41 maximal gleich groß ist wie oder sogar kleiner ist als der größere Weg von linkem Mindestweg 48 und rechtem Mindestweg 49, wenn die beiden Mindestwege 48, 39 unterschiedlich groß sind, oder maximal gleich groß ist wie oder kleiner ist als der linke Mindestweg 48 oder der rechte Mindestweg 49, wenn der linke Mindestweg 48 und der rechte Mindestweg 49 gleich groß sind.

Ein dem Temperiermittel im Eintrittsbereich 26 zur Durchströmung zur Verfügung stehender mittlerer Eintrittsbereichsquerschnitt 50 ist größer als ein im Austrittsbereich 27 dem Temperiermittel zur Durchströmung zur Verfügung stehender mittlerer Austrittsbereichsquerschnitt 51. Der jeweilige mittlere Querschnitt 50, 51 ist in den Figuren 10, 11, 13 und 14 jeweils durch einen Doppelpfeil angedeutet. Im Kanalsystem 7 variiert in der Hauptströmungsrichtung 42 ein nur in den Figuren 10, 13 und 14 eingetragener Abstand 52 zwischen der linken Kanalbegrenzungskontur 46 und der rechten Kanalbegrenzungskontur 47. Ferner weist das Kanalsystem 7 zwischen dem Zulauf IN und dem Ablauf OUT wenigstens einen Kanalabschnitt 53 auf, der sich in der Hauptströmungsrichtung 42 von einem Extremum E des Abstands 52 bis zum nächst folgenden Extremum E des Abstands 52 erstreckt. Das jeweilige Extremum E definiert ein Maximum MAX oder ein Minimum MIN und ist dadurch definiert, dass im jeweiligen Extremum E eine entlang des Abstands 52 verlaufende Gerade G senkrecht auf der linken Kanalbegrenzungskontur 46 und senkrecht auf der rechten Kanalbegrenzungskontur 47 steht. In Figur 10 ist repräsentativ ein Kanalabschnitt 53 im Eintrittsbereich 26 dargestellt, der in der Hauptströmungsrichtung 42 von einem Maximum MAX am Anfang des Kanalabschnitts 53 zu einem Minimum MIN am Ende des Kanalabschnitts 53 führt.

Der jeweilige Kanalabschnitt 53 weist eine entlang der Mittellinie 37 des Kanalabschnitts 53 gemessene Abschnittslänge 54 auf. Die Abschnittslänge 54 repräsentiert damit den Weg vom Anfang bzw. Maximum MAX entlang der Mittellinie 37 bis zum Ende bzw. Minimum MIN des jeweiligen Kanalabschnitts 53. Die Mittellinie 37 ist dabei durch die Mittelpunkte M von Geraden G bzw. Verbindungsgeraden G gebildet ist, die jeweils einen Punkt PL der linken Kanalbegrenzungskontur 46, der an der linken Kanalbegrenzungskontur 46 einen im Bereich von 0% bis 100% liegenden, prozentualen Längenanteil zwischen den beiden Extrema E besitzt, mit einem Punkt PR der rechten Kanalbegrenzungskontur 47 verbindet, der an der rechten Kanalbegrenzungskontur 47 denselben prozentualen Längenanteil zwischen den Extrema E besitzt. Exemplarisch sind in Figur 10 eingetragen sechs Geraden G, die sechs linke Punkte PL, die bei 0%, 25%, 50%, 75% und 100% der Länge der linken Kanalbegrenzungskontur 46 liegen, mit sechs rechten Punkten PR verbinden, die bei 0%, 25%, 50%, 75% und 100% der Länge der rechten Kanalbegrenzungskontur 47 liegen. Die Gerade G, die die bei 0% liegenden Punkte PL, PR verbindet, entspricht dem am Anfang des Kanalabschnitts 53 liegenden Maximum MAX und die Gerade G, die die bei 100% liegenden Punkte PL, PR verbindet, entspricht dem am Ende des Kanalabschnitts 53 liegenden Minimum MIN.

Die Kanalsystemgesamtlänge 41 ist durch die Summe der Abschnittslängen 54 aller vom Zulauf IN bis zum Ablauf OUT aufeinander folgender Kanalabschnitte 53 gebildet. Im Beispiel der Figur 10 weist das Kanalsystem 7 zwischen dem Zulauf IN und dem Ablauf OUT neunzehn Extrema E auf. Der Zulauf IN und der Ablauf OUT bilden jeweils auch ein Extremum E, nämlich jeweils ein Minimum MIN. In der Folge weist das Kanalsystem 7 im gezeigten Beilspiel der Figur 10 zwanzig Kanalabschnitte 53 auf, die in der Hauptströmungsrichtung 42 jeweils durch ein Minimum MIN und ein Maximum MAX bzw. durch zwei Extrema E begrenzt sind. Kanalabschnitte 53, die in der Hauptströmungsrichtung 42 unmittelbar aufeinanderfolgen grenzen über ein gemeinsames Extremum E aneinander an. Damit weisen der Eintrittsbereich 26, der Austrittsbereich 27 und auch der Verbindungsbereich 34 jeweils mehrere Kanalabschnitte 53 auf.

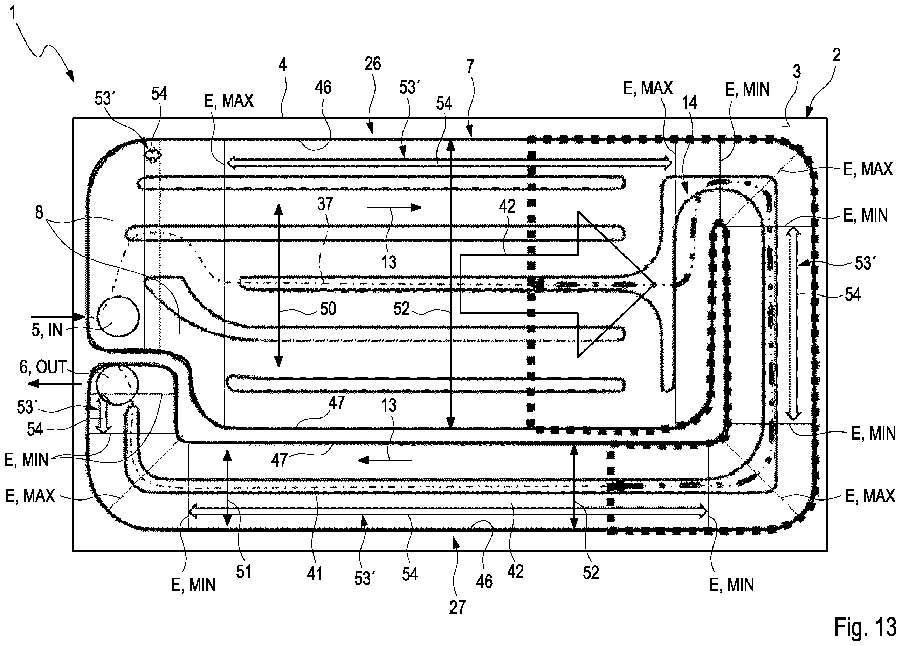

Die Kanalsysteme 7 sind in den Beispielen der Figuren 4, 13 und 14 identisch ausgestaltet. In den Figuren 13 und 14 sind zusätzlich zu Kanalabschnitten 53, in denen der Abstand 52 von einem Minimum MIN zu einem Maximum MAX zunimmt oder von einem Maximum MAX bis zu einem Minimum MIN abnimmt, jeweils mehrere Kanalabschnitte 53` vorhanden, in denen der Abstand 52 zwischen der linken und rechten Kanalbegrenzungskontur 46, 47 konstant ist. Die Kanalabschnitte 53` mit konstantem Abstand 52 sind in den Figuren 13 und 14 durch Doppelpfeile markiert, die jeweils die Abschnittslänge 54 des jeweiligen Kanalabschnitts 53' repräsentieren. Bei solchen Kanalabschnitten 53`, bei denen der Abstand 52 konstant ist, erstreckt sich dieser Kanalabschnitt 53` entlang des Extremums E, das ein Minimum MIN oder ein Maximum MAX sein kann, so dass am Anfang und am Ende eines derartigen Kanalabschnitts 53` jeweils ein Maximum MAX oder ein Minimum MIN vorliegen kann und den Übergang zum benachbarten Kanalabschnitt 53 bildet. In einem solchen Kanalabschnitt bildet der Abstand ein nicht näher bezeichnetes Plateau.

Der mittlere Eintrittsbereichsquerschnitt 50 ist nun durch ein dem Temperiermittel im Eintrittsbereich 26 zur Durchströmung zur Verfügung stehendes Eintrittsbereichsvolumen gebildet bezogen auf die Eintrittsbereichslänge. In der gleichen Weise ist der mittlere Austrittsbereichsquerschnitt 51 durch ein dem Temperiermittel im Austrittsbereich 27 zur Durchströmung zur Verfügung stehendes Austrittsbereichsvolumen bezogen auf die Austrittsbereichslänge gebildet. Die Eintrittsbereichslänge kann dabei bevorzugt durch die Summe der Abschnittslängen 54 aller im Eintrittsbereich 26 liegender Kanalabschnitte 53 gebildet sein. Die Austrittsbereichslänge kann dann durch die Summe der Abschnittslängen 54 aller im Austrittsbereich 27 liegender Kanalabschnitte 53 gebildet sein. Zweckmäßig ist das Kanalsystem 7 so konfiguriert, dass der mittlere Eintrittsbereichsquerschnitt 50 mindestens 50% größer ist als der mittlere Austrittsbereichsquerschnitt 51. Besonders zweckmäßig ist eine Konfiguration, bei der der mittlere Eintrittsbereichsquerschnitt 50 in einem Bereich von 70% bis 600%, vorzugsweise von 100% bis 400%, des mittleren Austrittsbereichsquerschnitts 51 liegt.

Ein dem Temperiermittel im Verbindungbereich 34 zur Durchströmung zur Verfügung stehender mittlerer Verbindungsbereichsquerschnitt 55 ist in Figur 10 durch einen Doppelpfeil angedeutet und ist zweckmäßig kleiner als der mittlere Eintrittsbereichsquerschnitt 50 und größer als der mittlere Austrittsbereichsquerschnitt 51. Dabei ist der mittlere Verbindungsbereichsquerschnitt 55 durch ein dem Temperiermittel im Verbindungsbereich 34 zur Durchströmung zur Verfügung stehendes Verbindungsbereichsvolumen bezogen auf eine Verbindungsbereichslänge gebildet, die sich vom Eintrittsbereich 26 bis zum Austrittsbereich 27 erstreckt. Dabei kann auch hier vorgesehen sein, dass die Verbindungsbereichslänge durch die Summe der Abschnittslängen 54 aller im Verbindungsbereich 34 liegender Kanalabschnitte 53 gebildet ist.

Zweckmäßig kann vorgesehen sein, dass das Kanalsystem 7 im Eintrittsbereich 26 einen kleineren Wärmeübergangskoeffizienten aufweist als im Austrittsbereich 27 und/oder als im Verbindungsbereich 34.

Nachfolgend wird anhand von Figur 11 eine alternative Vorgehensweise zur Ermittlung der Mittellinie 37 und damit der jeweiligen Kanallänge vorgestellt.

Der durchströmbare Querschnitt beschreibt die dem Temperiermittel zur Verfügung stehende lichte Öffnungsweite, also der sich aus der Breite und der Höhe ergebende Öffnungsquerschnitt abzüglich Noppen, Sicken und anderen Konturierungen. Für jede Stelle des Kanalsystems 7 wird gemäß Figur 11 die Kanalbreite als Schnitt durch das Kanalsystem 7 bestimmt. Der durchströmbare Querschnitt des Kanals 32 ist der dem Temperiermittel zur Verfügung stehende Öffnungsquerschnitt in diesem Schnitt. Als Kanallänge des Kanalsystems 7 bzw. im Eintrittsbereich 26, im Verbindungsbereich 34 und im Austrittsbereich 27 gilt bevorzugt die Länge der Mittellinie 37 im jeweiligen Kanalbereich.

Die Mittellinie 37 für den Eintrittsbereich 26, den Verbindungsbereich 34 und den Austrittsbereich 27 kann beispielsweise wie folgt ermittelt werden. Die Mittellinie 37 repräsentiert hier die Mittelpunkte M von Abständen A zwischen den seitlichen Kanalbegrenzungskonturen 46, 47, die in Figur 11 durch Doppelpfeile angedeutet sind und die in der Hauptströmungsrichtung 42 des Temperiermittels aufeinanderfolgen. Diese Abstände A repräsentieren dabei jeweils einen Kanaldurchmesser senkrecht zur Mittellinie 37 und können beispielsweise für einen Zulaufbereich ZB, einen Kanalbereich KB und einen Ablaufbereich AB wie folgt bestimmt werden.

Im Zulaufbereich ZB, in dem sich der Zulauf IN befindet, werden zentrisch zum Zulauf IN Kreise K erzeugt, die mit beiden Kanalbegrenzungskonturen 46, 47 je einen Schnittpunkt S aufweisen. Die beiden Schnittpunkte S des jeweiligen Kreises K werden durch eine Gerade miteinander verbunden, die den jeweiligen Abstand A der Kanalbegrenzungskonturen 46, 47 bzw. den Kanaldurchmesser definiert. Die geometrische Mitte dieses Abstands A bzw. Durchmessers ergibt den Mittelpunkt M, der einen Punkt der Mittellinie 37 repräsentiert. Mit zunehmendem Abstand A der Kanalbegrenzungskonturen 46, 47 ergeben sich so durch die Verbindung der Schnittpunkte S mit den Kanalbegrenzungskonturen 46, 47 Schnitte durch den Kanal mit zunehmendem Abstand A bzw. Kanaldurchmesser und demnach zunehmendem durchströmbaren Querschnitt. Ein Ende des Zulaufbereiches ZB liegt vor, wenn zumindest eines der folgenden Kriterien erfüllt ist:
a) Sobald der Durchmesser des Kreises K so groß wird, dass sich zwischen den Kreisen K und den beiden Kanalbegrenzungskonturen 46, 47 drei Kontaktpunkte und/oder Schnittpunkte S ergeben.
b) Sobald der Kreis K in eine Umlenkung des Kanals 32 läuft und damit über eine der beiden Kanalbegrenzungskonturen 46, 47 hinausläuft.

Im jeweiligen Kanalbereich KB, der sich zwischen dem Zulaufbereich ZB und dem Ablaufbereich AB befindet und damit weder den Zulauf IN noch den Ablauf OUT aufweist, ergeben sich in der Strömungsrichtung des Temperiermittels oftmals abwechselnd Bereiche, in denen der Abstand A bzw. der Kanaldurchmesser bzw. die Kanalbreite in der Strömungsrichtung zunimmt bzw. abnimmt. Normalerweise, also im Normalfall können der durchströmbare Querschnitt und die Mittellinie 37 mit einem Standardvorgehen bestimmt werden. Der Kanaldurchmesser beschreibt dabei in der Regel den kleinsten Abstand A der beiden Kanalbegrenzungskonturen 46, 47 und einzelne Schnitte durch den Kanal 32 werden dann durch eine tangentiale Anlage bzw. durch Kontaktpunkte der Kreise K an den beiden Kanalbegrenzungskonturen 46, 47 definiert. Mit anderen Worten, beim Standardvorgehen werden Kreise K erzeugt, die beide Kanalbegrenzungskonturen 46, 47 jeweils in einem Kontaktpunkt tangential berühren. Der Mittelpunkt M des jeweiligen Kreises K bildet dann einen Punkt der Mittellinie 37 des Kanals 32.

Dabei können in Kurven des Kanals 32 insbesondere folgende Sonderfälle auftreten. Wenn ein Radius der kurvenäußeren Kanalbegrenzungskontur 46, 47 am Kontaktpunkt des Kreises K kleiner ist als der Kreisradius, also kleiner ist als die Hälfte des Kanaldurchmessers, können sich folgende Szenarien ergeben:
Bei in der Strömungsrichtung abnehmendem Kanaldurchmesser kann sich folgender Zusammenhang ergeben. Werden die Kreise K stromab verschoben, reduziert sich der Abstand zwischen dem Kreismittelpunkt und den Kontaktpunkten mit den beiden Kanalbegrenzungskonturen 46, 47. In den Kontaktpunkten berühren sich der Kreis K und die jeweilige Kanalbegrenzungskontur 46, 47 tangential, so dass im jeweiligen Kontaktpunkt ein Kreisumfang und die Kanalbegrenzungskontur 46, 47 parallel zueinander verlaufen. Kreise K mit immer weiter abnehmendem Durchmesser werden in Strömungsrichtung so weit in den Kanal 32 "geschoben", bis beidseitige Kontaktpunkte mit tangentialer Anlage gefunden sind.

Potentielle weitere stromauf oder stromab liegende, nicht tangentiale Verschneidungspunkte der Kanalbegrenzungskonturen 46, 47 mit dem Kreis K werden dabei nicht berücksichtigt. Die so gefundenen Kontaktpunkte definieren einen Schnitt durch den Kanal 32, der zum gesuchten Kanalquerschnitt und über dessen Mittelpunkt M zur einem Punkt der Mittellinie 37 führt. Sobald der Kreis K so klein wird, dass er durch eine Engstelle des Kanals 32 "durchfällt" ohne in Kontakt mit beiden Kanalbegrenzungskonturen 46, 47 zu kommen, ist ein Bereich mit in Strömungsrichtung zunehmendem Kanaldurchmesser erreicht.

Bei einem besonders kleinen oder engen Radius der jeweiligen kurvenaußenliegenden Kanalbegrenzungskontur 46, 47 kann sich folgender Zusammenhang ergeben: Der Radius der kurvenäußeren Kanalbegrenzungskontur 46, 47 wird kleiner als der Kreisradius. In diesem Fall wird zur Definition des Schnitts, der den durchströmbaren Kanalquerschnitt und die Mittellinie 37 bestimmt, ein Punkt der kurvenäußeren Kanalbegrenzungskontur 46, 47 gewählt und die orthogonale Projektion auf die kurveninnere Kanalbegrenzungskontur 46, 47 repräsentiert dann den gewünschten Schnitt, der den durchströmbaren Kanalquerschnitt definiert und dessen Mittelpunkt M einen Punkt der Mittellinie 37 ergibt. Sobald am gewählten Punkt wieder eine tangentiale Anlage erreicht wird, kann wieder nach dem weiter oben beschriebenen Standardvorgehen mit tangentialer Anlage der Kreise K an den Kanalbegrenzungskonturen 46, 47 fortgefahren werden.

Bei in der Strömungsrichtung zunehmendem Kanaldurchmesser kann sich folgender Zusammenhang ergeben. Werden die Kreise K stromab verschoben, vergrößert sich der Abstand zwischen dem Kreismittelpunkt und den tangentialen Kontaktpunkten mit den beiden Kanalbegrenzungskonturen 46, 47. Die Kontaktpunkte definieren den Abstand A bzw. den Kanaldurchmesser des durchströmbaren Kanalquerschnitts und der Mittelpunkt M des Abstands A bzw. des Kanaldurchmessers liefert einen weiteren Punkt der Mittellinie 37. Sobald der Kreis K eine Stelle erreicht hat, in der keine weitere Vergrößerung mehr möglich ist, liegt ein Bereich mit in der Strömungsrichtung zunehmender Kanalbreite vor.

Bei einem besonders kleinen oder engen Radius der jeweiligen kurvenaußenliegenden Kanalbegrenzungskontur 46, 47 kann sich folgender Zusammenhang ergeben: Ist der Radius der kurvenäußeren Kanalbegrenzungskontur 46, 47 kleiner als der Kreisradius wird zur Definition des Querschnitts ein Punkt der kurvenäußeren Kanalbegrenzungskontur 46, 47 gewählt und die orthogonale Projektion auf die kurveninnere Kanalbegrenzungskontur 46, 47 stellt den gesuchten Querschnitt dar. Sobald am gewählten Punkt wieder eine tangentiale Anlage erreicht wird, kann nach dem Standardvorgehen mit tangentialer Anlage des Kreises K an beiden Kanalbegrenzungskonturen 46, 47 fortgefahren werden.

Im Ablaufbereich AB, in dem sich der Ablauf OUT befindet, können analog zum Zulaufbereich ZB zentrisch zum Ablauf OUT Kreise K erzeugt werden, die mit beiden Kanalbegrenzungskonturen 46, 47 je einen Schnittpunkt S aufweisen. Alternativ dazu lässt sich hier auch das Standardvorgehen für einen Kanalbereich mit in Strömungsrichtung abnehmendem Querschnitt anwenden.

Für die Mittellinie 37 gilt in jedem gefundenen Querschnitt, dass der Kanalquerschnitt, also das Produkt aus Kanalbreite und Kanalhöhe, von der Mittellinie 37 zu beiden Kanalbegrenzungskonturen 46, 47 hin gleich groß ist. Bei konstanter Kanalhöhe liegt die Mittellinie 37 in den Querschnitten genau in der Mitte zwischen den beiden Kanalbegrenzungskonturen 46, 47.

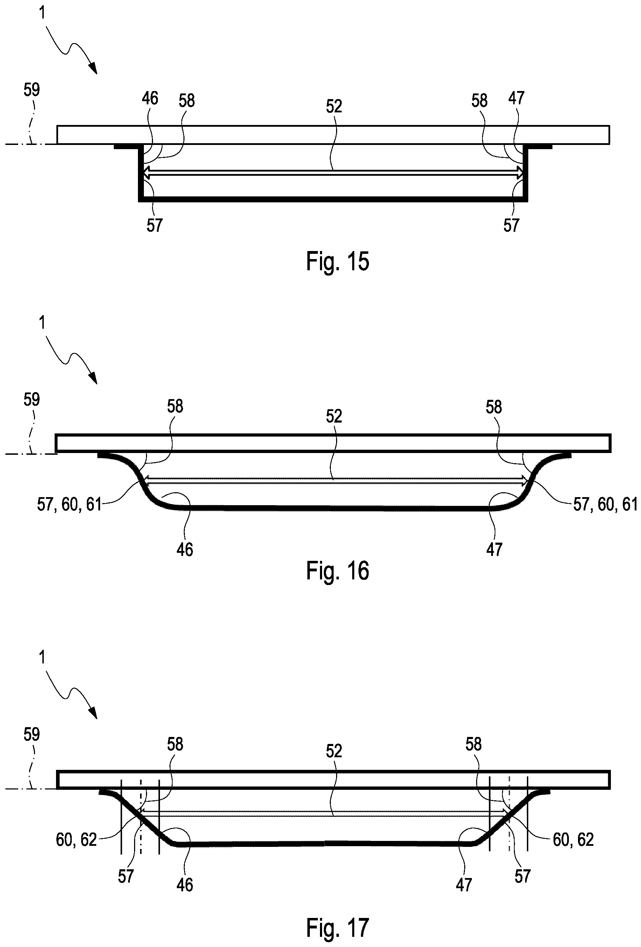

Gemäß den Figuren 15 bis 17 kann der Abstand 52 an der linken Kanalbegrenzungskontur 46 und an der rechten Kanalbegrenzungskontur 47 bezüglich einer nicht näher bezeichneten Dickenrichtung oder Höhenrichtung der Wärmeübertragerplatte 1 jeweils vorzugsweise mittig in einem Bereich 57 mit dem größten Neigungswinkel 58 gegenüber einer Plattenebene 59 gemessen werden, in der sich die Wärmeübertragungsplatte 1 erstreckt. Die Ausgestaltung des jeweiligen Kanals ist in den Figuren 15 bis 17 stark vereinfacht dargestellt. Die Höhen- oder Dickenrichtung steht senkrecht auf der Plattenebene 59 und verläuft in den Figuren 15 bis 17 vertikal. Die Plattenebene 59 erstreckt sich in den Figuren 15 bis 17 horizontal.

Im Beispiel der Figur 15 sind die beiden Kanalbegrenzungskonturen 46, 47 gerade konfiguriert und weisen exemplarisch einen Neigungswinkel 58 von 90° gegenüber der Plattenebene 59 auf. Andere Neigungswinkel 58 sind ebenfalls möglich. Jedenfalls ist bei Kanalbegrenzungskonturen 46, 47, die in der Höhenrichtung Z gerade sind, die Neigung zur Plattenebene 59 in der Höhenrichtung Z entlang der Kanalbegrenzungskontur 46, 47 konstant, sodass die Abstandsmessung bezüglich der Höhenrichtung Z in der Mitte der jeweiligen Kanalbegrenzungskontur 46, 47 erfolgt. In den Beispielen der Figuren 16 und 17 sind die beiden Kanalbegrenzungskonturen 46, 47 in ihrem Verlauf in der Höhenrichtung Z gekrümmt. Bei gekrümmten Kanalbegrenzungskonturen 46, 47 wird die steilste Stelle 60 der jeweiligen Kanalbegrenzungskontur 46, 47 zur Abstandsmessung herangezogen. In dieser Stelle 60 weist die jeweilige Kanalbegrenzungskontur 46, 47 den größten Neigungswinkel 58 gegenüber der Plattenebene 59 auf. Ist diese steilste Stelle 60 gemäß dem Beispiel der Figur 16 ein Punkt 61 der jeweiligen Kanalbegrenzungskontur 46, 47, erfolgt die Abstandsmessung bezüglich der Höhenrichtung Z in diesem Punkt 61. Ist diese steilste Stelle 60 dagegen wie im Beispiel der Figur 17 ein gerader Bereich 62 der jeweiligen Kanalbegrenzungskontur 46, 47 mit konstantem Neigungswinkel 58, erfolgt die Abstandsmessung bezüglich der Höhenrichtung Z in der Mitte dieses geraden Bereichs 62.

Sofern der jeweilige Bereich des Kanalsystems 7 mehrere parallel vom Temperiermittel durchströmte Strömungspfade aufweist, kann wie folgt vorgegangen werden. Die Strömung kann vom Zulauf IN bis zum Ablauf OUT als ein einziger Kanal oder als teilweise oder vollständig parallel verlaufende Kanäle betrachtet werden. Bei parallelen Kanälen wird die Strömungslänge für jeden Kanal analog der vorstehenden Beschreibung bestimmt und die Kanallänge als mit dem Kanalquerschnitt gewichteter Mittelwert der Längen der einzelnen Kanäle bestimmt. Im Falle von Verzweigungen und Vereinigungen wird so für alle Teilstücke durch Mittelwertbildung der mit den einzelnen Querschnitten gewichtete Länge sowie durch Aufsummieren der Einzelquerschnitte ein gemeinsamer Kanalquerschnitt bestimmt. Ein bestimmter Längenanteil bezieht sich im Bereich paralleler Strömungskanäle auf diese Mittelwerte und in Bereichen eines einzelnen Kanals auf die Mittellinie des Kanals.

Gemäß Figur 14 kann bei einer vorteilhaften Ausführungsform außerdem vorgesehen sein, dass das Kanalsystem 7 einen den Zulauf IN aufweisenden Verteilerbereich VB aufweist, der zumindest in den Figuren 1 bis 3, 5 bis 7 und 14 bezeichnet ist und der eine Verteilerbereichslänge aufweist. Außerdem weist das Kanalsystem 7 einen den Ablauf OUT aufweisenden Sammlerbereich SB auf, der zumindest in den Figuren 1 bis 3, 5 bis 7 und 14 bezeichnet ist und der eine Sammlerbereichslänge aufweist. Ferner kann das Kanalsystem 7 innerhalb der Temperierzone 30 einen Kontaktbereich KB bildet, der nur in Figur 14 bezeichnet ist und der an der Plattenoberfläche 3 zur wärmeübertragenden Kopplung mit dem jeweiligen zu temperierenden Bauteil 63 konfiguriert ist und der eine Kontaktbereichslänge aufweist, die sich vom Verteilerbereich VB bis zum Sammlerbereich SB erstreckt. Der weiter oben eingeführte Eintrittsbereich 26 erstreckt sich nun innerhalb des Kontaktbereichs KB und schließt an den Verteilerbereich VB an. Auch der weiter oben eingeführte Austrittsbereich 27 erstreckt sich innerhalb des Kontaktbereichs KB und schließt an den Sammlerbereich SB. Damit liegen der Verteilerbereich VB mit dem Zulauf IN und der Sammlerbereich SB mit dem Ablauf OUT außerhalb des Kontaktbereich KB, während der Eintrittsbereich 26, der Verteilerberiech 34 und der Austrittsbereich 27 innerhalb des Kontaktbereichs KB liegen. Erkennbar kann nun der Kontaktbereich KB so groß gewählt werden, dass damit das Bauteil 63, insbesondere die Traktionsbatterie 64 vollständig kontaktiert und vollständig temperiert werden kann.

Insbesondere kann dabei vorgesehen sein, dass die Eintrittsbereichslänge, die Austrittsbereichslänge und die Verbindungsbereichslänge jeweils 1/3 der Kontaktbereichslänge betragen. Vorteilhaft ist auch eine Konfiguration, bei der die Verteilerbereichslänge und die Sammlerbereichslänge jeweils maximal 15% der Kanalsystemgesamtlänge 41 betragen.

Bei einer anderen Ausführungsform kann vorgesehen sein, dass die Verteilerbereichslänge und die Sammlerbereichslänge jeweils 9,5% der Kanalsystemgesamtlänge 41 betragen. Alternativ dazu kann auch vorgesehen sein, dass die Verteilerbereichslänge und die Sammlerbereichslänge zusammen 19% der Kanalsystemgesamtlänge 41 betragen. Zusätzlich kann vorgesehen sein, dass die Eintrittsbereichslänge, die Austrittsbereichslänge und die Verbindungsbereichslänge jeweils 27% der Kanalsystemgesamtlänge 41 betragen. Alternativ dazu kann auch vorgesehen sein, dass die Eintrittsbereichslänge, die Austrittsbereichslänge und die Verbindungsbereichslänge zusammen 81% der Kanalsystemgesamtlänge 41 betragen.

Eine erfindungsgemäße Anordnung 65 einer Traktionsbatterie 64 an einer Wärmeübertragerplatte 1 der vorstehend beschriebenen Art charakterisiert sich gemäß Figur 14 dadurch, dass die Traktionsbatterie 64 innerhalb des Kontaktbereichs KB an der Plattenoberfläche 3 angeordnet und mit der Wärmeübertragerplatte 1 wärmeübertragend gekoppelt ist. Dabei können die Dimensionen der Traktionsbatterie 64 die Ausdehnung des Kontaktbereichs KB innerhalb des Kanalsystems 7 definieren. Mit anderen Worten, der Verteilerbereich VB und der Sammlerbereich SB liegen jeweils außerhalb der Traktionsbatterie 64, während der Kontaktbereich KB von der Traktionsbatterie 64 abgedeckt ist.

Die Anordnung 65 der Traktionsbatterie 64 an der Wärmeübertragerplatte 1 entspricht dabei einer ebenfalls mit 65 bezeichneten Einheit aus der Traktionsbatterie 64 und der Wärmeübertragerplatte 1, bei der die Traktionsbatterie 65 innerhalb des Kontaktbereichs KB an der Plattenoberfläche 3 angeordnet und mit der Wärmeübertragerplatte 1 wärmeübertragend gekoppelt ist.

Die Traktionsbatterie 64 kann dabei als einheitliche Baugruppe direkt an der Wärmeübertragerplatte 1 angeordnet sein. Die Traktionsbatterie 64 weist üblicherweise eine Vielzahl von nicht näher gezeigten Batteriezellen auf. Grundsätzlich können die Batteriezellen direkt an der Wärmeübertragerplatte 1 angeordnet sein. Ebenso ist denkbar, dass die Traktionsbatterie 64 mehrere Batteriemodule 66 aufweist, die jeweils mehrere Batteriezellen (nicht gezeigt) aufweisen. In diesem Fall können die Batteriemodule 66 direkt an der Wärmeübertragerplatte 1 angeordnet sein. Im Beispiel der Figur 14 sind sechs Batteriemodule 66 gezeigt.

## Patentansprüche

1. Wärmeübertragerplatte (1) zum Temperieren wenigstens eines elektrischen und/oder elektronischen Bauteils mittels eines flüssigen Temperiermittels,
- mit einem Plattenkörper (2), der eine Plattenoberfläche (3) zur wärmeübertragenden Kopplung mit dem jeweiligen zu temperierenden Bauteil und einen umlaufenden Plattenrand (4) aufweist,
- wobei der Plattenkörper (2) innerhalb des Plattenrands (4) wenigstens eine Temperierzone (30) aufweist, die einen am Plattenkörper (2) ausgebildeten Zulauf (IN) mit wenigstens einem Zulaufanschluss (5) zum Zuführen des Temperiermittels, einen am Plattenkörper (2) ausgebildeten Ablauf (OUT) mit wenigstens einem Ablaufanschluss (6) zum Abführen des Temperiermittels und ein im Plattenkörper (2) ausgebildetes Kanalsystem (7) zum Führen des Temperiermittels aufweist, das den Zulauf (IN) mit dem Ablauf (OUT) fluidisch verbindet,
- wobei das Kanalsystem (7) für das im Kanalsystem (7) vom Zulauf (IN) zum Ablauf (OUT) strömende Temperiermittel eine Hauptströmungsrichtung (42) definiert,
- wobei das Kanalsystem (7) bezüglich der Hauptströmungsrichtung (42) eine linke Kanalbegrenzungskontur (46) und eine rechte Kanalbegrenzungskontur (47) aufweist, die einen dem Temperiermittel zur Durchströmung zur Verfügung stehenden Querschnitt des Kanalsystems (7) quer zur Hauptströmungsrichtung (42) begrenzen,
- wobei das Kanalsystem (7) einen linken Mindestweg (48), der vom Zulauf (IN) entlang der linken Kanalbegrenzungskontur (46) zum Ablauf (OUT) führt, und einen rechten Mindestweg (49) definiert, der vom Zulauf (IN) entlang der rechten Kanalbegrenzungskontur (47) zum Ablauf (OUT) führt,
- wobei das Kanalsystem (7) vom Zulauf (IN) bis zum Ablauf (OUT) eine Kanalsystemgesamtlänge (41) aufweist,
- wobei das Kanalsystem (7) so konfiguriert ist, dass die Kanalsystemgesamtlänge (41) maximal 50% größer ist als der größere Weg von linkem und rechtem Mindestweg (48, 49) oder maximal 50% größer ist als der linke oder rechte Mindestweg (48, 49), wenn der linke und rechte Mindestweg (48, 49) gleich groß sind,
- wobei das Kanalsystem (7) einen Eintrittsbereich (26) aufweist, der eine Eintrittsbereichslänge aufweist, die sich über 20% bis 40% der Kanalsystemgesamtlänge (41) erstreckt,
- wobei das Kanalsystem (7) einen Austrittsbereich (27) aufweist, der eine Austrittsbereichslänge aufweist, die sich über 20% bis 40% der Kanalsystemgesamtlänge (41) erstreckt,
- wobei das Kanalsystem (7) einen Verbindungsbereich (34) aufweist, der den Eintrittsbereich (26) mit dem Austrittsbereich (27) verbindet,
- wobei ein dem Temperiermittel im Eintrittsbereich (26) zur Durchströmung zur Verfügung stehender mittlerer Eintrittsbereichsquerschnitt (50) größer ist als ein im Austrittsbereich (27) dem Temperiermittel zur Durchströmung zur Verfügung stehender mittlerer Austrittsbereichsquerschnitt (51).

2. Wärmeübertragerplatte (1) nach Anspruch 1,
**dadurch gekennzeichnet,**
- **dass** das Kanalsystem (7) so konfiguriert ist, dass die Kanalsystemgesamtlänge (41) maximal gleich groß ist wie der größere Weg von linkem und rechtem Mindestweg (48, 49) oder maximal gleich groß ist wie der linke oder rechte Mindestweg (48, 49), wenn der linke und rechte Mindestweg (48, 49) gleich groß sind.

3. Wärmeübertragerplatte (1) nach Anspruch 1 oder 2,
**dadurch gekennzeichnet,**
- **dass** das Kanalsystem (7) so konfiguriert ist, dass die Kanalsystemgesamtlänge (41) kleiner ist als der größere Weg von linkem und rechtem Mindestweg (48, 49) oder kleiner ist als der linke oder rechte Mindestweg (48, 49), wenn der linke und rechte Mindestweg (48, 49) gleich groß sind.

4. Wärmeübertragerplatte (1) nach einem der vorhergehenden Ansprüche,
**dadurch gekennzeichnet,**
- **dass** das Kanalsystem (7) einen den Zulauf (IN) aufweisenden Verteilerbereich (VB) aufweist, der eine Verteilerbereichslänge aufweist,
- **dass** das Kanalsystem (7) einen den Ablauf (OUT) aufweisenden Sammlerbereich (SB) aufweist, der eine Sammlerbereichslänge aufweist,
- **dass** das Kanalsystem (7) innerhalb der Temperierzone (30) einen Kontaktbereich (KB) bildet, der an der Plattenoberfläche (3) zur wärmeübertragenden Kopplung mit dem jeweiligen zu temperierenden Bauteil (63) konfiguriert ist und der eine Kontaktbereichslänge aufweist, die sich vom Verteilerbereich (VB) bis zum Sammlerbereich (SB) erstreckt,
- **dass** sich der Eintrittsbereich (26) innerhalb des Kontaktbereichs (KB) erstreckt und an den Verteilerbereich (VB) anschließt,
- **dass** sich der Austrittsbereich (27) innerhalb des Kontaktbereichs (KB) erstreckt und an den Sammlerbereich (SB) anschließt.

5. Wärmeübertragerplatte (1) nach Anspruch 4,
**dadurch gekennzeichnet,**
- **dass** die Eintrittsbereichslänge, die Austrittsbereichslänge und die Verbindungsbereichslänge jeweils 1/3 der Kontaktbereichslänge betragen.

6. Wärmeübertragerplatte (1) nach Anspruch 4 oder 5,
**dadurch gekennzeichnet,**
- **dass** die Verteilerbereichslänge und die Sammlerbereichslänge jeweils maximal 15% der Kanalsystemgesamtlänge (41) betragen.

7. Wärmeübertragerplatte (1) nach einem der vorhergehenden Ansprüche,
**dadurch gekennzeichnet,**
- **dass** die Verteilerbereichslänge und die Sammlerbereichslänge jeweils 9,5% oder zusammen 19% der Kanalsystemgesamtlänge (41) betragen,
- **dass** die Eintrittsbereichslänge, die Austrittsbereichslänge und die Verbindungsbereichslänge jeweils 27% oder zusammen 81% der Kanalsystemgesamtlänge (41) betragen.

8. Wärmeübertragerplatte (1) nach einem der vorhergehenden Ansprüche,
**dadurch gekennzeichnet,**
- **dass** im Kanalsystem (7) in der Hauptströmungsrichtung (42) ein Abstand (52) zwischen der linken und rechten Kanalbegrenzungskontur (46, 47) variiert,
- **dass** das Kanalsystem (7) zwischen dem Zulauf (IN) und dem Ablauf (OUT) wenigstens einen Kanalabschnitt (53) aufweist, der sich in der Hauptströmungsrichtung (42) von einem Extremum (E) des Abstands (52) bis zum nächstfolgenden Extremum (E) des Abstands (52) erstreckt,
- **dass** im jeweiligen Extremum (E) eine entlang des Abstands (52) verlaufende Gerade (G) senkrecht auf der linken Kanalbegrenzungskontur (46) und senkrecht auf der rechten Kanalbegrenzungskontur (47) steht,
- **dass** der jeweilige Kanalabschnitt (53) eine entlang einer Mittellinie (37) des Kanalabschnitts (53) gemessene Abschnittslänge (54) aufweist,
- **dass** die Mittellinie (37) durch die Mittelpunkte (M) von Verbindungsgeraden (G) gebildet ist, die jeweils einen Punkt (PL) der linken Kanalbegrenzungskontur (46), der an der linken Kanalbegrenzungskontur (46) einen im Bereich von 0% bis 100% liegenden, prozentualen Längenanteil zwischen den beiden Extrema (E) besitzt, mit einem Punkt (PR) der rechten Kanalbegrenzungskontur (47) verbindet, der an der rechten Kanalbegrenzungskontur (47) denselben prozentualen Längenanteil zwischen den Extrema (E) besitzt,
- **dass** die Kanalsystemgesamtlänge (41) durch die Summe der Abschnittslängen (54) aller vom Zulauf (IN) bis zum Ablauf (OUT) aufeinander folgender Kanalabschnitte (53) gebildet ist.

9. Wärmeübertragerplatte (1) nach einem der vorhergehenden Ansprüche,
**dadurch gekennzeichnet,**
- **dass** der mittlere Eintrittsbereichsquerschnitt (50) durch ein dem Temperiermittel im Eintrittsbereich (26) zur Durchströmung zur Verfügung stehendes Eintrittsbereichsvolumen bezogen auf die Eintrittsbereichslänge gebildet ist,
- **dass** der mittlere Austrittsbereichsquerschnitt (51) durch ein dem Temperiermittel im Austrittsbereich (27) zur Durchströmung zur Verfügung stehendes Austrittsbereichsvolumen bezogen auf die Austrittsbereichslänge gebildet ist.

10. Wärmeübertragerplatte (1) nach den Ansprüchen 8 und 9,
**dadurch gekennzeichnet,**
- **dass** die Eintrittsbereichslänge durch die Summe der Abschnittslängen (54) aller im Eintrittsbereich (26) liegender Kanalabschnitte (53) gebildet ist,
- **dass** die Austrittsbereichslänge durch die Summe der Abschnittslängen (54) aller im Austrittsbereich (27) liegender Kanalabschnitte (53) gebildet ist.

11. Wärmeübertragerplatte (1) nach einem der vorhergehenden Ansprüche,
**dadurch gekennzeichnet,**
- **dass** der mittlere Eintrittsbereichsquerschnitt (50) mindestens 50% größer ist als der mittlere Austrittsbereichsquerschnitt (51).

12. Wärmeübertragerplatte (1) nach Anspruch 11,
**dadurch gekennzeichnet**
- **dass** der mittlere Eintrittsbereichsquerschnitt (50) in einem Bereich von 70% bis 600%, vorzugsweise von 100% bis 400%, des mittleren Austrittsbereichsquerschnitts (51) liegt.

13. Wärmeübertragerplatte (1) nach einem der vorhergehenden Ansprüche,
**dadurch gekennzeichnet,**
- **dass** ein dem Temperiermittel im Verbindungbereich (34) zur Durchströmung zur Verfügung stehender mittlerer Verbindungsbereichsquerschnitt (55) kleiner ist als der mittlere Eintrittsbereichsquerschnitt (50) und größer ist als der mittlere Austrittsbereichsquerschnitt (51).

14. Wärmeübertragerplatte (1) nach Anspruch 13,
**dadurch gekennzeichnet,**
- **dass** der mittlere Verbindungsbereichsquerschnitt (55) durch ein dem Temperiermittel im Verbindungsbereich (34) zur Durchströmung zur Verfügung stehendes Verbindungsbereichsvolumen bezogen auf eine Verbindungsbereichslänge gebildet ist, die sich vom Eintrittsbereich (26) bis zum Austrittsbereich (27) erstreckt.

15. Wärmeübertragerplatte (1) nach den Ansprüchen 8 und 14,
**dadurch gekennzeichnet,**
- **dass** die Verbindungsbereichslänge durch die Summe der Abschnittslängen (54) aller im Verbindungsbereich (34) liegender Kanalabschnitte (53) gebildet ist.

16. Wärmeübertragerplatte (1) nach einem der vorhergehenden Ansprüche,
**dadurch gekennzeichnet,**
- **dass** das Kanalsystem (7) im Eintrittsbereich (26) einen kleineren Wärmeübergangskoeffizienten aufweist als im Austrittsbereich (27) und/oder im Verbindungsbereich (34).

17. Wärmeübertragerplatte (1) nach einem der vorhergehenden Ansprüche,
**dadurch gekennzeichnet,**
- **dass** das Kanalsystem (7) mehrere Pfade (43) aufweist, die jeweils das Temperiermittel vom Zulauf (IN) durch einen Verteilerkanal (8) zu einem Verbindungskanal (9), vom Verbindungskanal (9) zu einem Sammelkanal (10) und vom Ablaufkanal (10) zum Ablauf (OUT) führen und jeweils eine Pfadlänge aufweisen,
- **dass** jeder Pfad (43), dessen Pfadlänge kleiner ist als 50%, insbesondere kleiner ist als 60%, vorzugsweise kleiner ist als 75%, der Pfadlänge des längsten Pfads (43), einen kurzen Pfad (43) bildet,
- **dass** die Summe der kleinsten durchströmbaren Querschnitte (45) aller kurzen Pfade (43) kleiner ist als 40%, insbesondere kleiner ist als 20%, vorzugsweise kleiner ist als 10%, der Summe der kleinsten durchströmbaren Querschnitte (45) aller anderen Pfade (43).

18. Verwendung einer Wärmeübertragerplatte (1) nach einem der vorhergehenden Ansprüche zum Temperieren von Batteriezellen einer Traktionsbatterie eines batterieelektrischen Fahrzeugs.

19. Anordnung (65) einer Traktionsbatterie (64) an einer Wärmeübertragerplatte (1) nach Anspruch 4 oder nach Anspruch 4 und einem der Ansprüche 5 bis 17,
- wobei die Traktionsbatterie (64) innerhalb des Kontaktbereichs (KB) an der Plattenoberfläche (3) angeordnet und mit der Wärmeübertragerplatte (1) wärmeübertragend gekoppelt ist.
